(19) **Europäisches Patentamt**

**European Patent Office**

**Office européen des brevets**

(11) **EP 0 745 861 B1**

(12) **EUROPÄISCHE PATENTSCHRIFT**

(45) Veröffentlichungstag und Bekanntmachung des Hinweises auf die Patenterteilung:
**07.11.2001  Patentblatt 2001/45**

(51) Int Cl.$^7$: **G01R 27/26**, G01R 17/02

(21) Anmeldenummer: **96890093.6**

(22) Anmeldetag: **31.05.1996**

(54) **Kapazizätsmessverfahren und -vorrichtung**

Method and device for measuring capacitances

Procédé et dispositif de mesure de capacités

(84) Benannte Vertragsstaaten:
**AT CH DE FR GB IT LI SE**

(30) Priorität: **01.06.1995  AT  93195**

(43) Veröffentlichungstag der Anmeldung:
**04.12.1996  Patentblatt 1996/49**

(73) Patentinhaber: **AVL Gesellschaft für Verbrennungskraftmaschinen und Messtechnik mbH.Prof.Dr.Dr.h.c. Hans List
8020 Graz (AT)**

(72) Erfinder: **Klementschitz, Peter
A-8430 Leibnitz (AT)**

(74) Vertreter: **Gibler, Ferdinand, Dipl.Ing. Dr. techn. Patentanwalt
Dorotheergasse 7
1010 Wien (AT)**

(56) Entgegenhaltungen:
**EP-A- 0 025 029        EP-A- 0 285 070
WO-A-91/09812        FR-A- 2 531 227
US-A- 4 054 833        US-A- 4 558 595**

## Beschreibung

Die Erfindung betrifft ein Verfahren zum Messen kleiner Kapazitäten mit einer selbstabgleichenden Brückenschaltung, wobei die Kapazität oder die Kapazitätsänderung eines unbekannten Kondensators in einem Brückenzweig bzw. die Kapazitäten oder die Kapazitätsänderung zweier unbekannter Kondensatoren in zwei verschiedenen Brückenzweigen bestimmt wird und die aus Referenzkondensatoren und einem unbekannten Kondensator oder unbekannten Kondensatoren gebildete Brücke an zwei ersten Diagonalpunkten mit einer periodischen, im wesentlichen rechteckförmigen Spannung mit konstanter Amplitude gespeist wird, wobei die Rechteckspannung in einer Periode jeweils von einem ersten auf einen zweiten Pegel wechselt.

Bekannte Verfahren dieser Art werden vor allem in der Sensorik bei der Messung sehr kleiner Kapazitäten bzw. Kapazitätsänderungen angewendet und haben den Nachteil einer sehr geringen erreichbaren Meßfrequenz, sodaß sehr lange Meßzeiten in Kauf genommen werden müssen.

Aus der WO-91/09812 ist eine Schaltungsanordnung zur Bestimmung von Kapazitätsänderungen bekanntgeworden, bei der ein Rechteckoszillator eine Brückenschaltung speist, deren Zweige mit einem veränderbaren bzw. festen Kondensator und mit je einem Zweig aus einer Kapazitätsdiode gebildet sind. Die an den Diagonalpunkten der Brücke anliegende Brückenspannung wird über Koppelkondensatoren an die Eingänge eines Differenzverstärkers gelegt, welcher die Differenzspannung verstärkt und dessen Ausgangsspannung über einen Tiefpaß und einen Gegenkopplungszweig an einen der Diagonalpunkte zum Abgleich der Brückenschaltung rückgeführt wird. Der andere Diagonalpunkt wird über eine Abgleich-Schaltung auf einem vorbestimmbaren Potential gehalten.

Der Nachteil dieser bekannten Schaltungsanordnung besteht in der Verwendung von Kapazitätsdioden zum Einstellen des Brückengleichgewichts, wodurch Koppelkondensatoren zur Gleichspannungsabtrennung für den Eingang des Differenzverstärkers notwendig sind. Weiters kann der zu messende Kondensator in dieser bekannten Schaltung nicht mit Masse verbunden sein, sodaß sich daraus eine Beschränkung für viele Anwendungen, z.B. der Sensorik, ergibt.

In der EP-B-0 285 070 ist ein Verfahren zum Messen der Kapazität eines einstellbaren Kondensators und wenigstens eines festen Bezugskondensators in einer Brückenschaltung geoffenbart, in dem der Bezugskondensator und die Meßkapazität an einem gemeinsamen Knoten miteinander verbunden sind und eine feste Spannung direkt über die Anschlüsse eines der Kondensatoren und eine einstellbare Spannung direkt über die Anschlüsse des anderen Kondensators zum Laden während einer ersten Phase eines sich wiederholenden Zweiphasenmeßzyklus angelegt sind, und die Kondensatoren in einer Regelschleife während der zweiten Phase verbunden werden, wobei die Änderung des Potentials an dem genannten Knoten erkannt wird und das Laden der Kondensatoren automatisch modifiziert wird, sodaß die Änderung des Potentials über mehrere Meßzyklen auf Null verringert wird, und wobei die Ladungsänderungen integriert und danach die einstellbare Spannung bestimmt wird und diese Spannung proportional der Kapazität des einstellbaren Kondensators ist.

Nachteilig an diesem Verfahren ist die Verwendung zweier Spannungsquellen zum Laden des Meß- und Referenzkondensators, wodurch die Abhängigkeiten dieser Spannungen von den Umgebungsparametern, z.B. Temperatur, in das Meßergebnis eingehen.

Aufgabe der Erfindung ist es daher, ein Verfahren der eingangs genannten Art anzugeben, mit dem kleine Kapazitäten mit sehr hoher Meßfrequenz und damit sehr schnell gemessen werden können.

Ein weiteres Ziel der Erfindung ist es, eine sehr hochauflösende Messung der unbekannten Kondensatoren zu ermöglichen.

Schließlich besteht eine weitere Aufgabe der Erfindung darin, eine sehr gute Temperaturstabilität der Messung zu erreichen.

Dies wird erfindungsgemäß dadurch erreicht, daß fortlaufend nur während des zweiten Pegels des Rechtecksignals die Spannungsdifferenz an zwei zweiten Diagonalpunkten der Brücke in einem Synchronverstärker, vorzugsweise einem Komparator, leerlaufverstärkt wird, und während des ersten Pegels der Synchronverstärker ein vorbestimmtes Potential abgibt, sodann das leerlaufverstärkte Ausgangssignal des Synchronverstärkers mittels eines Reglers, vorzugsweise eines Integralreglers, auf einen Sollwert geregelt wird, welcher Sollwert durch den Zeitmittelwert der Ausgangsspannung des Synchronverstärkers bei abgeglichener Brücke festgelegt ist, daß mittels der Ausgangspannung des Reglers über einen Gegenkopplungszweig und eine abgleichbare Klemmschaltung die Brücke an den zweiten Diagonalpunkten in Abgleich gebracht wird, wobei die Ausgangsspannung des Reglers im wesentlichen proportional der Kapazität oder der Kapazitätsänderung des unbekannten Kondensators bzw. der unbekannten Kondensatoren ist.

Durch diese Maßnahmen kann eine sehr hohe Meßfrequenz erreicht werden, da beispielsweise bei Integralregelung sehr schnelle Regelzeiten möglich sind. Es wird dabei während des zweiten Pegels des Rechtecksignals durch den Potentialvergleich an den zweiten Diagonalpunkten die Brückenverstimmung ermittelt, und die Stellgröße der Regelung, die die Abweichung der verstärkten Differenzspannung vom Mittelwert der Ausgangsspannung des Synchronverstärkers darstellt, als ein der Verstimmung proportionaler Meßwert erfaßt.

In weiterer Ausbildung der Erfindung kann vorgesehen sein, daß die integrierte Spannung mit einem Tiefpaß-Filter geglättet wird, wobei die geglättete Ausgangsspannung proportional der Kapazität oder der Kapazitätsänderung des unbekannten Kondensators bzw. der unbekannten Kondensatoren ist.

Dadurch kann die Zeitkonstante des Integriervorganges klein gehalten und die Welligkeit des Ausgangssignals durch die Tiefpaß-Filterung verringert werden.

Weiters kann vorgesehen sein, daß zur quasistatischen Kapazitätsmessung die geglättete Ausgangsspannung in einem weiteren Integralregler in bezug auf einen weiteren Sollwert integriert und diese integrierte Spannung einem dem Abgleich dienenden Eingang der Klemmschaltung zugeführt wird, wobei die geglättete Ausgangsspannung proportional der Kapazität oder der Kapazitätsänderung des unbekannten Kondensators bzw. der unbekannten Kondensatoren ist.

Durch diese Maßnahmen können sehr langsame Kapazitätsänderungen gemessen werden, die insgesamt größer als die dem Meßsignal entsprechende Kapazität sind.

Ein weiteres Ziel der Erfindung ist es, eine Schaltungsanordnung zur Durchführung des erfindungsgemäßen Verfahrens anzugeben.

Dies wird bei einer aus Referenzkondensatoren und einer oder zwei unbekannten Kapazitäten gebildeten Brückenschaltung, welche an den zwei ersten Diagonalpunkten mit einem Rechteckgenerator verbunden ist, der eine konstante im wesentlichen rechteckförmige Rechteckausgangsspannung liefert, erfindungsgemäß dadurch erreicht, daß die zwei zweiten Diagonalpunkte mit den Eingängen eines Synchronverstärkers verbunden sind, welcher die Differenz der an den beiden zweiten Diagonalpunkten gemessenen Potentiale nur während des zweiten Pegels des Rechteckgenerators verstärkt, daß der Ausgang des Synchronverstärkers mit einem ersten Eingang eines Reglers, vorzugsweise eines Integralreglers, verbunden und während des ersten Pegels der Rechteckspannung auf einem vorbestimmbaren Potential gehalten ist, und der Ausgang des Reglers mit dem Eingang einer Gegenkopplungsschaltung verbunden ist, daß deren Ausgang mit einem ersten Eingang einer Klemmschaltung verbunden ist, daß ein zweiter Eingang des Reglers mit einer konstanten Sollspannungsquelle verbunden ist und ein erster bzw. zweiter Ausgang der Klemmschaltung mit den beiden zweiten Diagonalpunkten verbunden sind, wobei ein zweiter Eingang der Klemmschaltung mit einer Abgleichsspannungsquelle verbunden ist und daß am Ausgang des Reglers eine dem Wert des unbekannten Kondensators bzw. der unbekannten Kondensatoren oder deren Änderungen proportionale Ausgangsspannung abgreifbar ist.

Durch diese Maßnahmen ist die Ausgangsspannung der erfindungsgemäßen Schaltungsanordnung direkt proportional zur Brückenverstimmung, ratiometrisch zur Versorgungsspannung und unabhängig von der Frequenz der Brückenspeisung. Der Schaltungsaufwand ist relativ gering, da übliche Standardbauteile verwendet werden können. Deshalb ist die Schaltung auch für integrierte Anwendungen sehr vorteilhaft.

In diesem Zusammenhang kann weiters vorgesehen sein, daß dem Ausgang des Integralreglers ein Tiefpaß-Filter nachgeschaltet ist.

Dadurch kann die Welligkeit des Ausgangssignals des Integralreglers, besonders wenn dieser eine sehr kleine Zeitkonstante hat, vermindert werden.

Besonders vorteilhaft in Hinblick auf die Erhöhung der Grenzfrequenz der Messung ist es dabei, wenn das Tiefpaß-Filter ein aktives Tiefpaß-Filter ist.

Besonders gute Meßergebnisse werden erzielt, wenn das aktive Tiefpaß-Filter ein zweipoliges Filter ist und an dessen Ausgang ein RC-Tiefpaß nachgeschaltet ist.

Bei einer besonders bevorzugten Ausführungsform der Erfindung kann vorgesehen sein, daß das aktive Tiefpaß-Filter durch einen Operationsverstärker mit einer zwischen Ausgang und invertierendem Eingang gekoppelten Parallelschaltung aus einem Kondensator und einem Widerstand gebildet ist, und daß der nichtinvertierende Eingang mit einer konstanten Referenzspannung verbunden ist.

In weiterer Ausgestaltung der Erfindung kann vorgesehen sein, daß das aktive Tiefpaß-Filter mehrpolig ist.

Dadurch ist es möglich die Welligkeit der Ausgangsspannung noch weiter zu reduzieren.

Weiters kann vorgesehen sein, daß der Synchronverstärker aus einem Differenzverstärker gebildet ist, wobei der Ausgang des Differenzverstärkers zur Synchronisation mit einem Widerstand und einem vom Rechtecksignal gesteuerten Schalter in Serie verbunden ist.

Dadurch läßt sich ein sehr einfacher und kostengünstiger Aufbau eines erfindungsgemäßen Synchronverstärkers erreichen.

Gemäß einer weiteren Variante der Erfindung kann der Synchronverstärker durch eine Abtast- und Halteschaltung gebildet sein.

Dadurch vereinfacht sich die synchrone Verstärkung des von der Brücke kommenden Differenzsignals.

Gemäß einer besonders bevorzugten Ausführungsart kann vorgesehen sein, daß der Synchronverstärker durch einen Pulsbreitenmodulator gebildet ist und die Pulsmodulation durch die Abhängigkeit der Antwortzeit des Ausgangs eines Differenzverstärkers von der Größe der Spannung am Eingang des Differenzverstärkers erfolgt.

Durch diese Maßnahmen wird eine hohe Verstärkung bei gleichzeitig sehr hoher Meßfrequenz ermöglicht. Weiters ergibt sich eine besonders niedrige Temperaturabhängigkeit dieser Anordnung.

Besonders bevorzugt ist eine Variante der Erfindung, die darin besteht, daß der Pulsbreitenmodulator einen Komparator umfaßt, dessen Eingänge mit den beiden zweiten Diagonalpunkten verbunden sind, wobei die Antwortzeit des Ausgangssignals des Komparators eine Funktion des an seinem Eingang angelegten Spannungswertes ist.

Dadurch ergibt sich eine Pulsbreitenmodulation, die über die entsprechende Antwort-Kennlinie des Komparators mit der Verstimmung der Brücke in funktionalem Zusammenhang steht.

In diesem Zusammenhang kann vorgesehen sein, daß der Ausgang des Komparators zur Synchronisation über einen Pull-up-Widerstand mit dem Ausgang des Rechteckgenerators verbunden ist.

Dadurch wird eine synchronisierte Pulsbreitenmodulation erreicht.

Weiters kann zur Synchronisierung des Komparators der Komparator einen Latch- oder Inhibit- Eingang aufweisen.

Zur Umwandlung des Spannungsausgangs eines Komparators in einen Open-Collector-Ausgang ist es besonders vorteilhaft, wenn der Ausgang des Komparators mit einer Basis eines Schalttransistors mit kurzer Schaltzeit verbunden ist, dessen Kollektor einen Open-Collector bildet.

In einer weiteren bevorzugen Ausführungsform der Erfndung kann vorgesehen sein, daß der Integralregler aus einem Differenzverstärker gebildet ist, bei dem ein Integrierkondensator zwischen Ausgang und invertierendem Eingang vorgesehen ist, welcher invertierender Eingang über einen Widerstand den Eingang des Integralreglers bildet und bei dem der nichtinvertierende Eingang mit einer Sollspannungsquelle verbunden ist, wobei die Zeitkonstante des Integralreglers durch das Produkt von Widerstand und Integrierkondensator bestimmt ist.

Diese Bauteilkombination läßt einen sehr einfachen Aufbau der erfindungsgemäßen Schaltungsanordnung zu.

Gemäß einer erfindungsgemäßen Variante kann die Zeitkonstante des Integralreglers größer oder gleich der Periode der Ausgangsspannung des Rechteckgenerators sein.

Dadurch kann der Brückenabgleich während jeder Periode auf einfache Weise erreicht werden.

Bei einer besonders bevorzugten Ausführungsform der Erfindung ist vorgesehen, daß das Verhältnis der Zeitkonstante des Integralreglers zur Periodendauer des Rechtecksignals in einem Bereich zwischen 1 und 10 liegt.

Dadurch können besonders schnelle Kapazitätsmessungen mit hohen Meßfrequenzen durchgeführt werden.

Besonders bevorzugt ist dabei, wenn die Sollspannungsquelle eine konstante Spannung aufweist, deren Wert ein 1/4 des Hochpegels des Rechteckgenerators beträgt, für den Fall, daß der Ausgang des Synchronverstärkers in der Tiefpegelphase auf Masse liegt.

In weiterer Ausbildung der Erfindung kann vorgehen sein, daß die Gegenkopplungsschaltung aus einem ersten mit einem der zweiten Diagonalpunkte verbundenen Gegenkopplungswiderstand und einem mit diesem verbundenen zweiten Gegenkopplungswiderstand, der an seinem anderen Ende mit Masse verbunden ist, gebildet ist.

Dadurch kann auf einfache Weise die Gesamtverstärkung des Synchronverstärkers und des Integralreglers festgelegt werden.

Eine weitere Variante der Erfindung kann darin bestehen, daß die Klemmschaltung über einen ersten Klemmwiderstand einen der zweiten Diagonalpunkte mit dem Verbindungspunkt zwischen den Gegenkopplungswiderständen verbindet und über einen zweiten Klemmwiderstand den anderen der zweiten Diagonalpunkte mit dem Abgriffspunkt eines aus Widerständen gebildeten Spannungsteiler verbindet, wobei eine am zweiten Eingang der Klemmschaltung anliegende Abgleichspannung durch den Spannungsteiler geteilt wird.

Dadurch kann auf einfache Weise eine Gegenkopplung der Ausgangsspannung des Integralreglers für die zweiten Diagonalpunkte der Brücke erreicht werden, wobei die Klemmwiderstände auf die gewünschte Grenzfrequenz und die dabei vorliegende Phasendrehung abgestimmt werden müssen, um eine Rückkopplung zu vermeiden.

Vorzugsweise ist dabei zum ersten bzw. zweiten Klemmwiderstand eine erste bzw. zweite Klemmdiode parallel geschaltet.

Durch diese Maßnahme können die Klemmwiderstände sehr hochohmig ausgeführt werden, wodurch die Kondensatoren der Brückenschaltung in geringerem Ausmaß entladen werden.

Dabei ist es besonders vorteilhaft, wenn die erste und die zweite Klemmdiode als Doppeldiode in einem Gehäuse angeordnet sind.

Dadurch kann bei Temperaturschwankungen die Nullpunktsdrift der erfindungsgemäßen Schaltungsanordnung minimiert werden.

Schließlich besteht eine weitere Ausführungsform der Erfindung darin, daß ein weiterer Integralregler zwischen dem Ausgang des Tiefpaß-Filters und dem zweiten Eingang der Klemmschaltung geschaltet ist.

Dadurch kann eine quasistatische Messung der Kapazitäten durchgeführt werden, sodaß auch sehr langsame Änderungen nicht die Auflösung der Messung verschlechtern. Weiters hat diese Maßnahme den Vorteil, daß der Eingang der erfindungsgemäßen Schaltungsanordnung nicht leicht übersteuert werden kann.

In weiterer Ausbildung der Erfindung kann vorgesehen sein, daß an den Verbindungspunkt zwischen Begrenzungswiderstand und Brücke eine Kompensationsschaltung über einen Widerstand angeschlossen ist.

Dadurch wird auf einfache Weise ein Kompensieren verschiedener äußerer Einflüsse wie Temperatur o.ä. oder der Nichtlinearität des Ausgangssignals in bezug auf eine andere physikalische Größe ermöglicht.

In diesem Zusammenhang kann vorgesehen sein, daß zur Kompensation des Temperaturganges einer der Kompensationseingänge über einen temperaturabhängigen Widerstand mit einer temperaturstabilen Referenzspannung verbunden sind.

Dadurch kann die Messung auf einfache Weise von Temperaturänderungen der Umgebung unabhängig gemacht werden.

Ein weiteres Merkmal der Erfindung kann sein, daß zur Kompensation des Temperaturganges die beiden Kompensationseingänge mit einem aktiven Temperatursensor verbunden sind.

Auf diese Weise kann eine die Messung nur sehr wenig beeinflussende Kompensation des Temperaturganges erzielt werden.

Weiters kann vorgesehen sein, daß zur Kompensation der Nichtlinearität der der Kapazität bzw. der Kapazitätsänderung proportionalen Ausgangsspannung der Kompensationseingang über einen Linearisierungs-Widerstand mit dem Ausgang des Integralreglers bzw. dem Ausgang des Tiefpaß-Filters verbunden ist, und das Verhältnis von Widerstand zu Linearisierungs-Widerstand gleich vs-1 beträgt, wobei v die Verstärkung, s= C3/(Cp + C3) ist und Cp eine konstante zu C1 parallele Kapazität darstellt.

Dadurch gelingt es z.B. eine zu einem Abstand indirekt proportionale Kapazitätsänderung zu linearisieren.

Die Erfindung wird im folgenden anhand der in den Zeichnungen dargestellten Ausführungsformen näher erläutert. Dabei zeigt

Fig.1a ein Schaltbild einer erfindungsgemäßen Brückenschaltung;

Fig.1b eine Darstellung der an der Brücke anliegenden bzw. abgreifbaren Pegel in Abhängigkeit von der Zeit;

Fig.2a und Fig.2b ein Blockschaltbild einer erfindungsgemäßen Schaltungsanordnung zur Durchführung des erfindungsgemäßen Verfahrens;

Fig.3 Ausgangsspannungen verschiedener Ausführungsformen von Synchronverstärkern;

Fig.4a eine Kennlinie der Eingangsübersteuerung eines Komparators in Abhängigkeit von der Antwortzeit seines Ausganges;

Fig.4b ein Schaltbild eines synchronisierten Komparators;

Fig.4c den Verlauf einer erfindungsgemäßen Pulsbreitenmodulation in Abhängigkeit von der Zeit;

Fig.5 ein Blockschaltbild einer erfindungsgemäßen Schaltungsanordnung;

Fig.6 eine äußere Beschaltung der Schaltungsanordnungen gemäß Fig. 8 oder 9 zur Temperaturkompensation;

Fig.7 eine äußere Beschaltung der Schaltungsanordnungen gemäß Fig. 8 oder 9 zur Linearitätskompensation und

Fig.8 und 9 Ausführungsformen von erfindungsgemäßen Schaltungsanordnungen mit Kompensationseingängen.

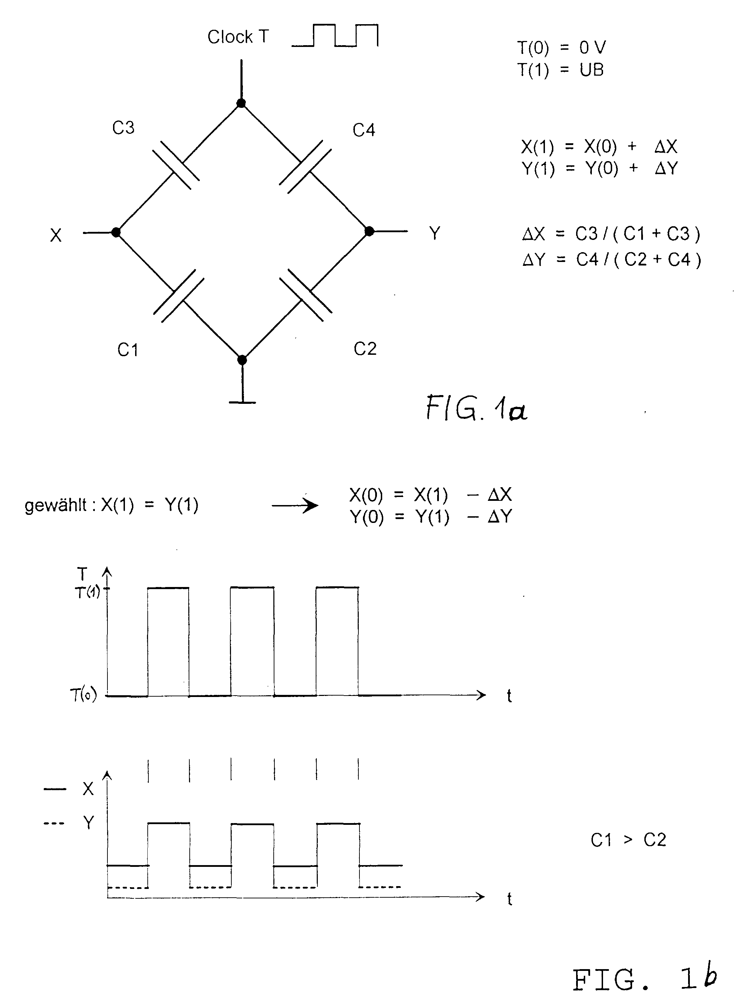

In Fig. 1a ist eine beim erfindungsgemäßen Verfahren verwendete Brückenschaltung A gezeigt, wobei die Kapazität oder die Kapazitätsänderung eines unbekannten Kondensators C1 in einem Brückenzweig bzw. die Kapazitäten oder die Kapazitätsänderung zweier unbekannter Kondensatoren C1, C2 in zwei verschiedenen Brückenzweigen bestimmt wird. Die aus Referenzkondensatoren C2, C3, C4 bzw. C3, C4 und einem unbekannten Kondensator C1 oder unbekannten Kondensatoren C1, C2 gebildete Brücke A wird an zwei ersten Diagonalpunkten, die mit Clock T und Masse verbunden sind, mit einer periodischen, im wesentlichen rechteckförmigen Spannung T mit konstanter Amplitude gespeist, wobei die Rechteckspannung T in einer Periode jeweils von einem ersten T(0) auf einen zweiten Pegel T(1) wechselt, wie aus dem Spannungs-Zeitdiagramm in Fig. 1b zu erkennen ist.

Erfindungsgemäß wird fortlaufend nur während des zweiten Pegels T(1) des Rechtecksignals die Spannungsdifferenz an zwei zweiten Diagonalpunkten X, Y der Brücke A in einem Synchronverstärker D, vorzugsweise einem Komparator, leerlaufverstärkt. Während des ersten Pegels T(0) gibt der Synchronverstärker D ein vorbestimmtes Potential ab. Das leerlaufverstärkte Ausgangssignal des Synchronverstärkers wird mittels eines Reglers, vorzugsweise eines Integralreglers E, auf einen Sollwert geregelt, welcher Sollwert durch den Zeitmittelwert der Ausgangsspannung des Synchronverstärkers bei abgeglichener Brücke festgelegt ist. Mittels der Ausgangspannung des Reglers E wird über einen Gegenkopplungszweig G und eine abgleichbare Klemmschaltung C die Brücke A an den zweiten Diagonalpunkten X, Y in Abgleich gebracht wird, wobei die Ausgangsspannung des Reglers E im wesentlichen proportional der Kapazität oder der Kapazitätsänderung des unbekannten Kondensators C1 bzw. der unbekannten Kondensatoren C1, C2 ist.

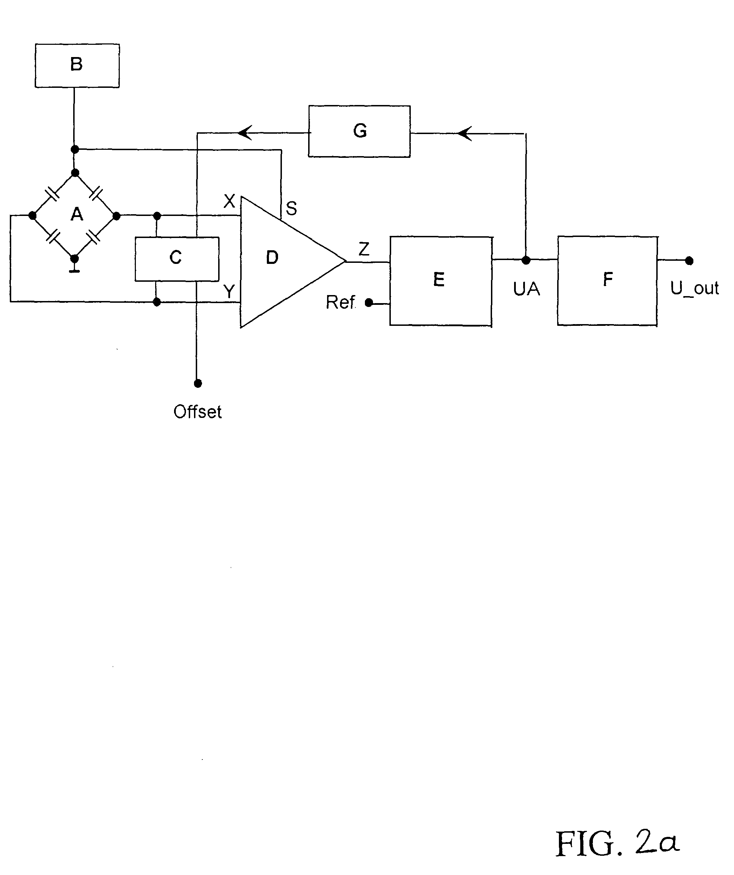

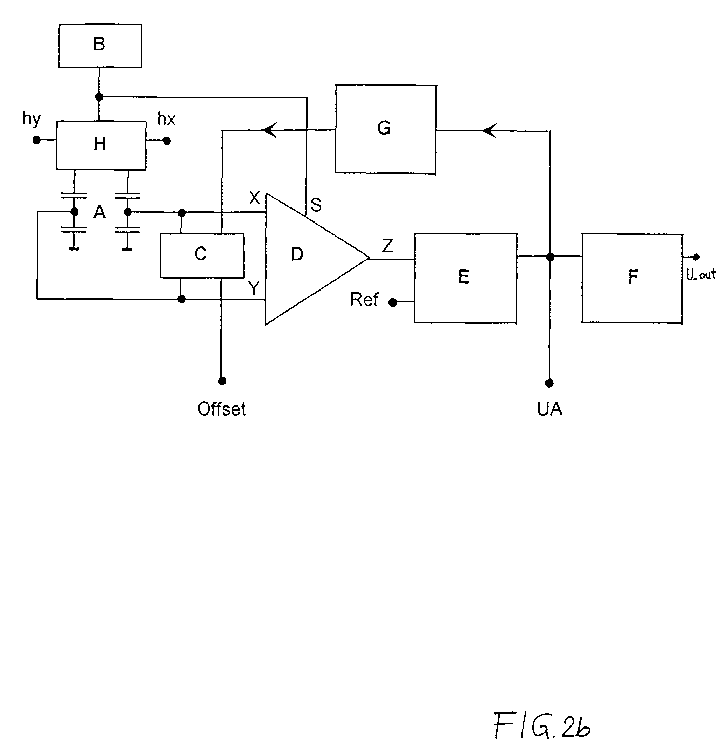

Je eine Ausführungsform der Erfindung ist anhand eines Blockschaltbildes in Fig. 2a und Fig. 2b beschrieben, wobei der Regler E als Integralregler ausgeführt ist, die integrierte Spannung mit einem Tiefpaß-Filter F geglättet wird und die geglättete Ausgangsspannung U_out proportional der Kapazität oder der Kapazitätsänderung des unbekannten Kondensators C1 bzw. der unbekannten Kondensatoren C1, C2 ist.

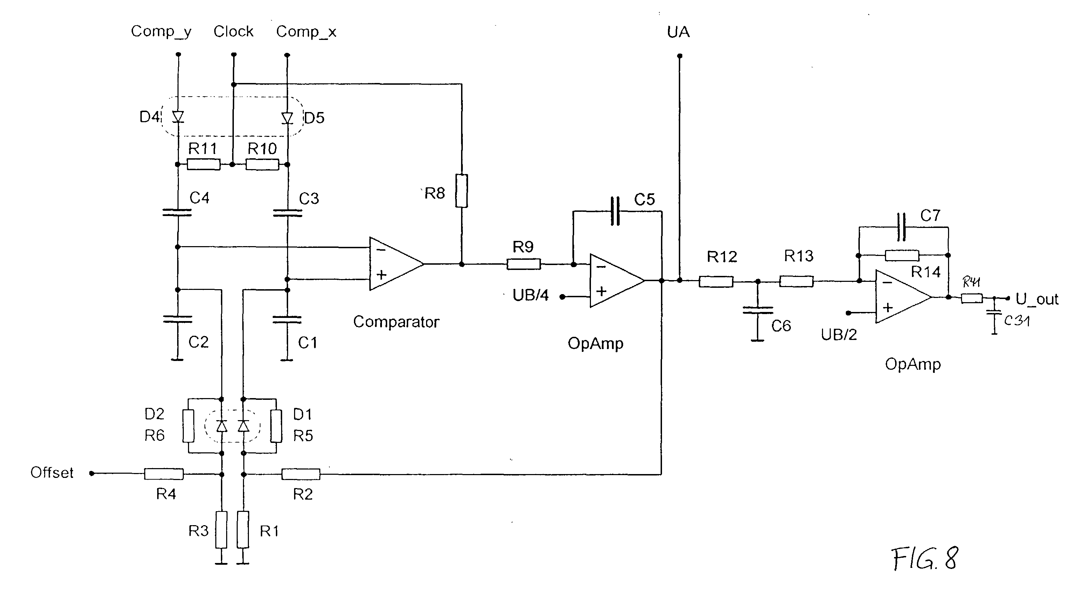

Das in Fig.2b gezeigte Blockschaltbild unterscheidet sich von dem in Fig.2a durch eine Linearisierungsschaltung H, die zwischen Brückengenerator B und der Brücke A geschaltet ist. Die konkrete Ausgestaltung einer solchen Schaltung ist in Fig.8 wiedergegeben.

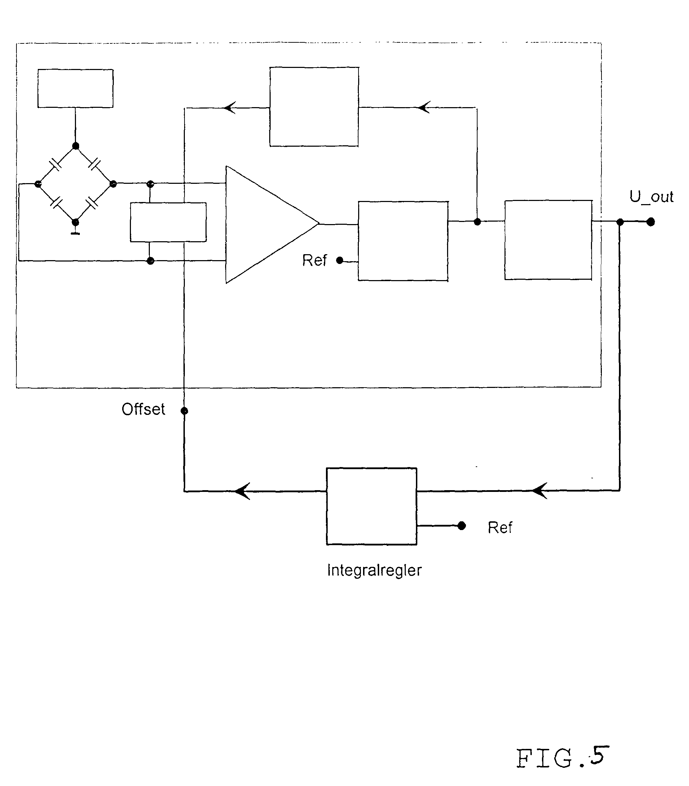

In Fig.5 ist eine weitere Ausführungsform des erfindungsgemäßen Verfahren und der erfindungsgemäßen Schaltungsanordnung dargestellt, wobei zur quasistatischen Kapazitätsmessung die geglättete Ausgangsspannung in einem weiteren Integralregler E in bezug auf einen weiteren Sollwert integriert und diese integrierte Spannung einem dem Abgleich dienenden Eingang (Offset) der Klemmschaltung C zugeführt wird, wobei die geglättete Ausgangsspannung proportional der Kapazität oder der Kapazitätsänderung des unbekannten Kondensators C1 bzw. der Kapazitätsdifferenz oder deren Änderung der unbekannten Kondensatoren C1, C2 ist.

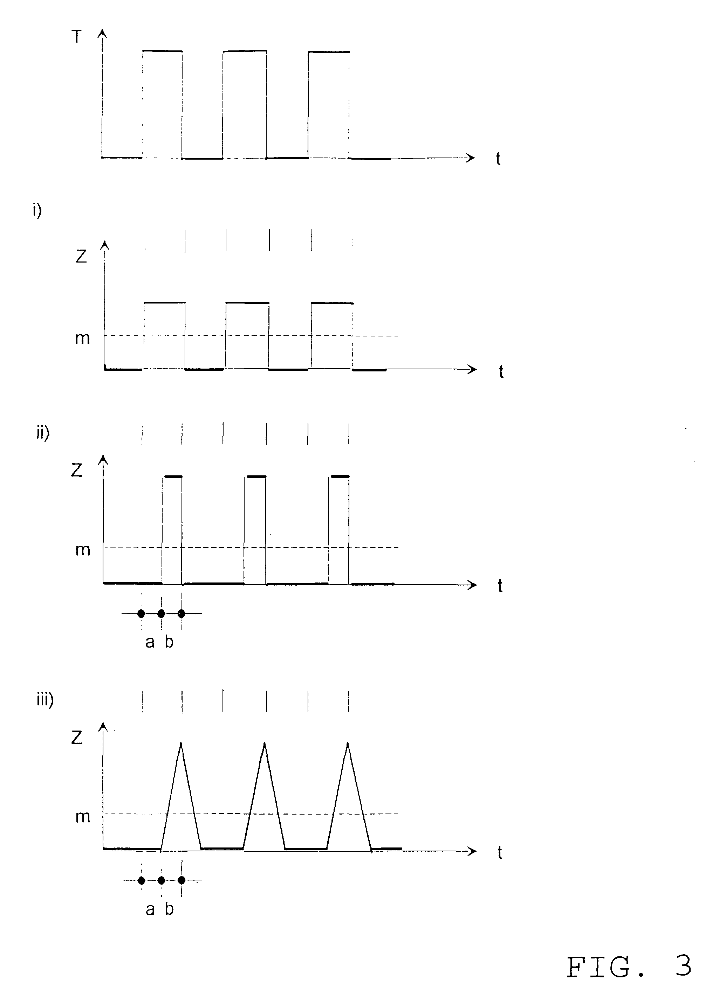

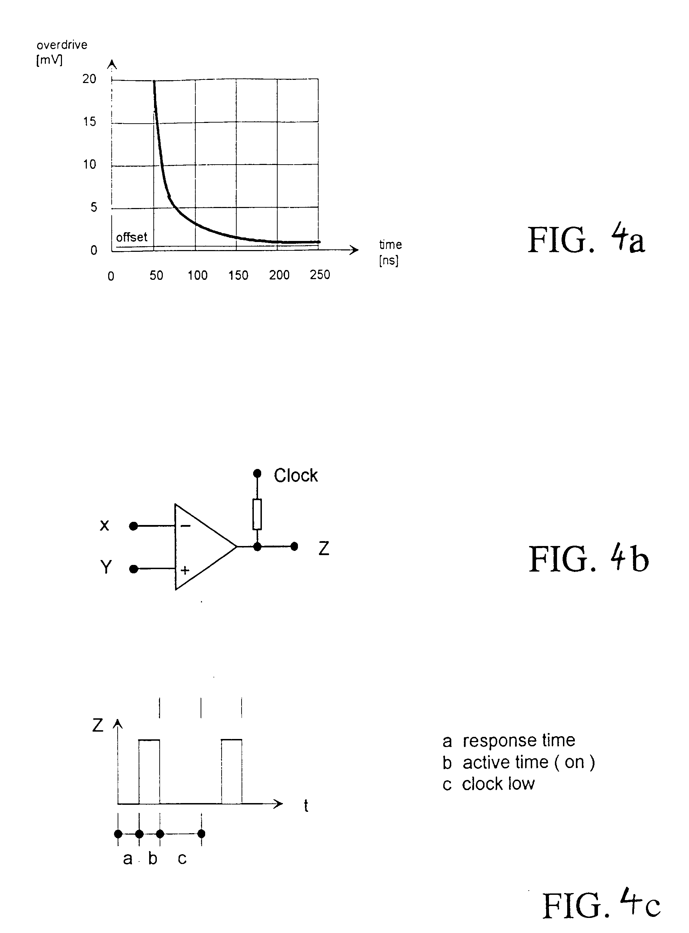

Zur Erklärung der Wirkungsweise des erfindungsgemäßen Synchronverstärkers sind in Fig.3 die Speisespannung T der Brücke A und die Ausgangsspannungen verschiedener Ausführungsformen von Synchronverstärkern dargestellt. Dabei kann es sein, daß der Synchronverstärker D aus einem Differenzverstärker gebildet ist, wobei der Ausgang des Differenzverstärkers zur Synchronisation über einen Widerstand mit dem Rechteckgenerator B verbunden ist (Fig.4b). Die Ausgangsspanung eines solchen mit seiner Leerlaufverstärkung betriebenenen Differenzverstärkers ist in Fig.3 i) gezeigt.

Weiters kann der Synchronverstärker D durch eine Abtast- und Halteschaltung gebildet sein.

Eine bevorzugte Ausführungsform ist es, wenn der Synchronverstärker D durch einen Pulsbreitenmodulator gebildet ist und die Pulsmodulation durch die Abhängigkeit der Antwortzeit des Ausgangs eines Differenzverstärkers von der Größe der Spannung am Eingang des Differenzverstärkers erfolgt. Der zugehörige Spannungsverlauf am Ausgang eines solchen Pulsbreitenmodulators ist in Fig. 3ii) für niedrige und in Fig. 3iii) für hohe Frequenzen angegeben.

Durch die Antwortzeit der Leerlaufverstärkung eines Komparators ergibt sich die in Fig.4a gezeigte Charakteristik, die eine Pusbreitenmodulation des Eingangssignals ermöglicht. Dabei umfaßt der Pulsbreitenmodulator einen Komparator, dessen Eingänge mit den beiden zweiten Diagonalpunkten X, Y verbunden sind, wobei die Antwortzeit des Ausgangssignals des Komparators eine Funktion des an seinem Eingang angelegten Spannungswertes ist. Dabei kann der gewählte Arbeitspzunkt beispielsweise so gewählt werden, daß bei einer Übersteuerung von 2mV die Antwortzeit 150ns beträgt. Die daraus resultierende Pulsbreitenmodulation zeigt Fig.4c.

Die in Fig. 8 dargestellte Schaltungsanordnung zur Durchführung des Verfahrens weist eine aus Referenzkondensatoren C2, C3, C4 bzw. C3, C4 und einer oder zwei unbekannten Kapazitäten C1 bzw. C1, C2 gebildete Brückenschaltung A auf, die an den zwei ersten Diagonalpunkten mit einem Spannungsgenerator B verbunden ist, der eine konstante im wesentlichen rechteckförmige Rechteckausgangsspannung T liefert.

Erfindungsgemäß ist dabei vorgesehen, daß die zwei zweiten Diagonalpunkte X, Y mit den Eingängen eines Synchronverstärkers D, hier durch einen Komparator ausgeführt, verbunden sind, welcher die Differenz der an den beiden zweiten Diagonalpunkten X, Y gemessenen Potentiale nur während des zweiten Pegels T(1) des Rechteckgenerators B leerlaufverstärkt, daß der Ausgang des Synchronverstärkers D mit einem ersten Eingang eines Reglers, vorzugsweise eines Integralreglers E, verbunden und während des ersten Pegels T(0) der Rechteckspannung auf einem vorbestimmten Potential gehalten ist, und der Ausgang des Reglers E über einen Gegenkopplungszweig R2, R1 mit dem Eingang einer Klemmschaltung C verbunden ist, wobei ein zweiter Eingang des Reglers E mit einer konstanten Sollspannungsquelle UB/4 verbunden ist, und ein erster bzw. zweiter Ausgang der Klemmschaltung C mit den beiden zweiten Diagonalpunkten X, Y verbunden sind, wobei ein zweiter Eingang Offset der Klemmschaltung C mit einer Abgleichsspannungsquelle verbunden ist. Am Ausgang des Integralreglers E ist eine dem Wert des unbekannten Kondensators bzw. der unbekannten Kondensatoren oder deren Änderungen proportionale Ausgangsspannung abgreifbar.

Dabei ist in diesem Ausführungsbeispiel weiters vorgesehen, daß dem Ausgang des Integralreglers E ein Tiefpaß-Filter F nachgeschaltet ist. Das Tiefpaß-Filter F ist in Fig. 8 als aktives zweipoliges Tiefpaß-Filter ausgebildet, an dessen Ausgang ein RC-Tiefpaß R41, C31 nachgeschaltet ist. Das aktive Tiefpaß-Filter F kann aber auch mehrpolig ausgebildet sein.

Die im wesentlichen rechteckförmige Speisespannung für die Brücke A kann durch einen handelsüblichen Quarzoszillator in integrierter Form erzeugt werden, der den Vorteil eines geringen Platzbedarfes und eines niedrigen Preises aufweist.

Um einen handelsüblichen Komparator zu einem Synchronverstärker umzufunktionieren, kann wie in Fig. 8 gezeigt, der Ausgang des Komparators zur Synchronisation über einen Pull-up-Widerstand R8 mit dem Ausgang des Rechteckgenerators B verbunden sein.

Der Integralregler E aus Fig. 8 ist erfindungsgemäß aus einem Differenzverstärker gebildet, bei dem ein Integrierkondensator C5 zwischen Ausgang und invertierendem Eingang vorgesehen ist, welcher invertierender Eingang über einen Widerstand R9 den Eingang des Integralreglers bildet und bei dem der nichtinvertierende Eingang mit einer Sollspannungsquelle verbunden ist, wobei die Zeitkonstante des Integralreglers durch das Produkt von Widerstand R9 und Integrierkondensator C9 bestimmt ist.

Vorteilhaft ist es dabei, wenn die Zeitkonstante des Integralreglers E größer oder gleich der Periode der Ausgangsspannung des Rechteckgenerators B ist.

Besonders bevorzugt ist dabei ein Bereich, in dem das Verhältnis der Zeitkonstante des Integralreglers zur Periodendauer des Rechtecksignals in einem Bereich zwischen 1 und 10 liegt. Für eine gute Ausnützung des vorhandenen Modulationshubes der Pulsbreitenmodulation weist Sollspannungsquelle eine konstante Spannung auf, deren Wert ein Viertel des ersten Pegels des Rechteckgenerators B beträgt.

Die Gegenkopplungsschaltung G ist in Fig. 8 aus einem ersten mit einem der zweiten Diagonalpunkte verbundenen Gegenkopplungswiderstand R2 und einem mit diesem verbundenen zweiten Gegenkopplungswiderstand R1 gebildet, der an seinem anderen Ende mit Masse verbunden ist. Die Klemmschaltung C verbindet über einen ersten Klemmwiderstand R5 einen der zweiten Diagonalpunkte mit dem Verbindungspunkt zwischen den Gegenkopplungswiderständen R2, R1 und über einen zweiten Klemmwiderstand R6 den anderen der zweiten Diagonalpunkte mit dem Abgriffspunkt eines aus Widerständen R3, R4 gebildeten Spannungsteiler, wobei eine am zweiten Eingang (Offset) der Klemmschaltung anliegende Abgleichsspannung durch den Spannungsteiler geteilt wird. Zum ersten bzw. zweiten Klemmwiderstand R5 bzw. R6 ist dabei eine erste bzw. zweite Klemmdiode D1 bzw. D2 parallel geschaltet, wobei es für die Temperaturstabilisierung vorteilhaft ist, wenn die erste und die zweite Klemmdiode D1, D2 als Doppeldiode in einem Gehäuse angeordnet sind.

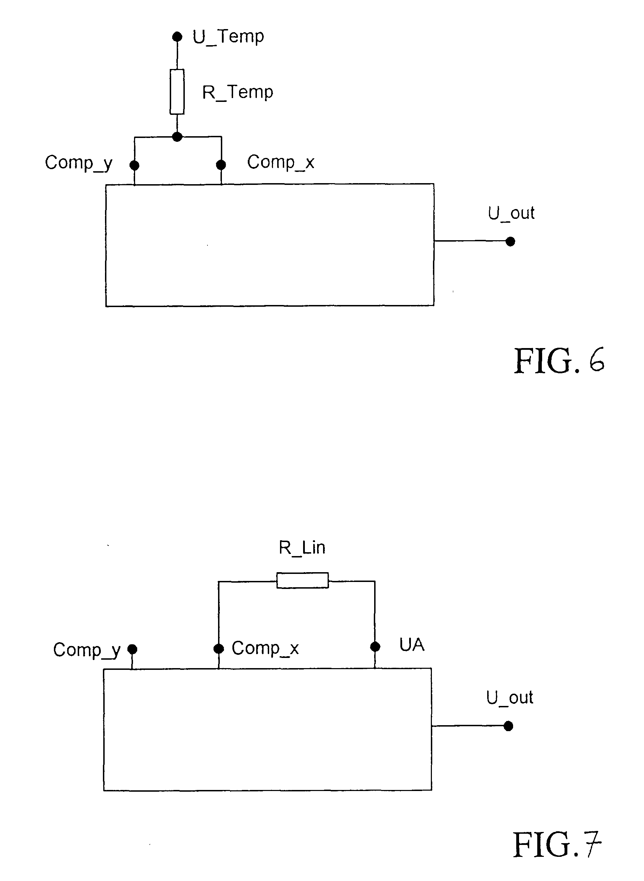

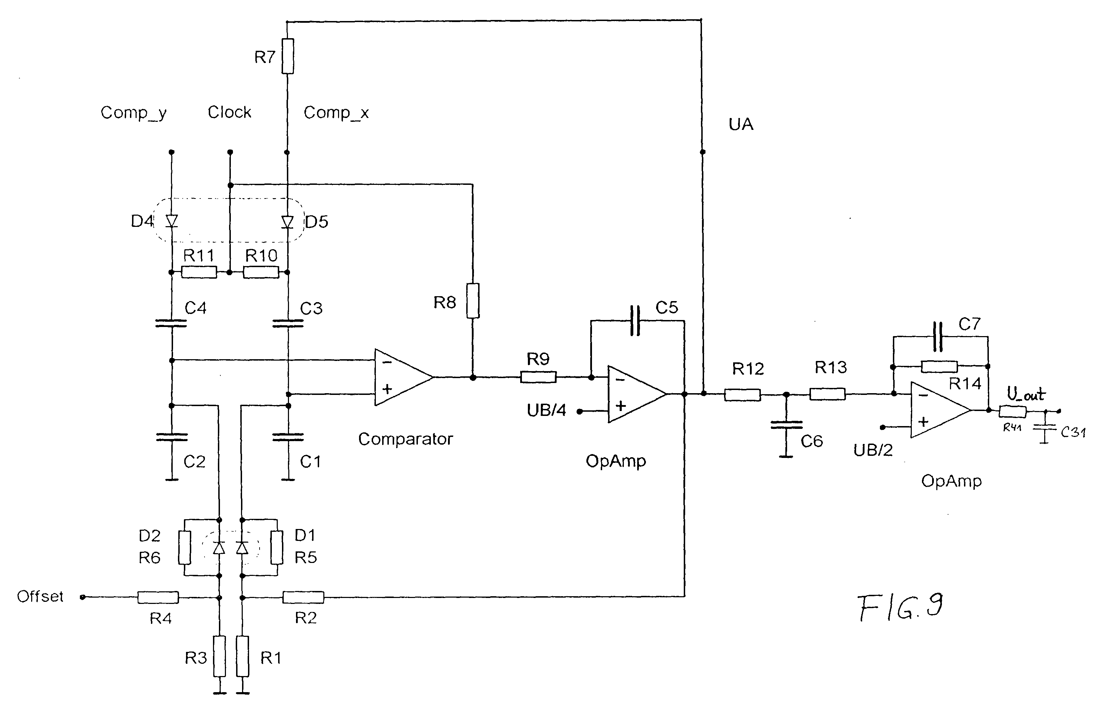

In den Ausführungsbeispielen nach Fig.8 und 9 ist gemäß Fig.2b die Ausgangsspannung (Clock) des Rechteckgenerators B über je einen Widerstand R10, R11 mit den Referenzkondensatoren C3, C4 verbunden, wobei die Verbindungspunkte der Widerstände R10, R11 mit den Referenzkondensatoren C3, C4 über je eine Diode D5, D4 Kompensationseingänge Comp_x, Comp_y bilden, die wie in Fig.6 und Fig.7 beschaltet werden können. Zur Temperaturkompensation wird dabei eine temperaturstabile Referenzspannung U_Temp über einen temperaturabhängigen Widerstand R_Temp oder ein aktiver Temperatursensor mit den beiden Kompensationseingängen verbunden. Zur Linearitätskompensation wird ein Linearisierungswiderstand R_Lin (bzw. R7 in Fig.9) mit einem der Kompensationseingänge Comp_x verbunden.

Für eine solche Schaltung sind die zu Fig.9 weiter unten angegebenen Gleichungen gültig. Der nicht benötigte Eingang Comp_y soll bei dieser Form der Linearisierung auf eine Spannung, die etwas größer als die Durchlaßspannung einer Diode ist, also etwa 1,5 bis 2V, gelegt werden. Dies hat den Vorteil, daß der Temperaturgang der Dioden ausbalanciert wird. Für eine verbesserte Temperaturstabiität können die Dioden D4, D5 als Schottky-Dioden in einem gemeinsamen Gehäuse ausgeführt sein.

## 1. Allgemeines

Dieses Schaltprinzip wurde entwickelt zum Messen kleinster Kapazitäten bei gleichzeitig hoher Meßfrequenz, hoher Auflösung und großer Temperaturstabilität. Die Ausgangsspannung ist direkt proportional zur Brückenverstimmung, ratiometrisch zur Versorgungsspannung und unabhängig von der Frequenz der Brückenspeisung. Die Brückenspeisung erfolgt mit einem symmetrischen Rechtecksignal und wird im folgenden kurz als 'Clock' bezeichnet.

Der Schaltungsaufwand ist gering, und es werden übliche Standardbauteile verwendet. Die Schaltung ist sehr gut für einen integrierten Aufbau in einem ASIC-Chip geeignet.

Typisches Anwendungsgebiet ist die Sensorik.

## 2. Meßbrücke

Fig. 1a :

Die Brücke ist als Wheatstone-Brücke aufgebaut und wird mit dem Clock-Signal versorgt. Die Brückenelemente C1... C4 sollen für eine optimale Empfindlichkeit in etwa den gleichen Wert haben. Es kann entweder nur C1 oder C1 und C2 ( Differentialkondensator) gemessen werden.

Der typische Kapazitätswert der Brückenelemente liegt unter 100pF, bei größeren Werten muß die Clock-Frequenz entsprechend niedriger gewählt werden oder man muß die Schaltung für einen hohen Stromverbrauch umdimensionieren.

Das Clock-Signal hat in der Low-Phase (= T (0)) eine Spannung von null Volt, in der High-Phase (= T(1) ) die Versorgungsspannung +UB. Da im folgenden die Verstärkung direkt proportional zu Brückenversorgungsspannung ist und dadurch in der High-Phase gleich +UB, ist eine stabilisierte Versorgungsspannung sehr wichtig.

An den Punkten X, Y ergeben sich die Spannungsänderungen $\Delta X$, $\Delta Y$.

In Fig. 1bwerden auch die Spannungsdiagramme für das Clocksignal T und für für die Meßpunkte X, Y gezeigt.

Die Meßpunkte X,Y können im Prinzip jede beliebige Gleichspannung aufweisen, denn durch die Kondensatoren C1...C4 sind sie gleichspannungsmäßig entkoppelt. Der Gleichspannungsanteil wird hier so gewählt, daß zum Zeitpunkt (1) gilt :

$$X(1)=Y(1).$$

Zwangsläufig ergibt sich dann für den Zeitpunkt (0):

$$X(0) = X(1) - \Delta X, \quad Y(0) = Y(1) - \Delta Y.$$

Dies hat schaltungsmäßig den Vorteil, daß der Spannungsvergleich X(1) = Y(1) bei ungefähr UB/2 erfolgt und somit kein Problem mit dem Meßbereich besteht. Bei einer Wahl von X(0) = Y(0) = 0 Volt im Zeitpunkt (0) wäre dies nicht der Fall.

Die Grundidee der darauf basierenden Schaltung besteht darin, den Gleichspannungsanteil in den Punkten X,Y so nachzuregeln, daß zum Zeitpunkt(1) diese Punkte die gleiche Spannung aufweisen. Die Regelspannung ist dabei direkt proportional zur Verstimmung der Brücke und stellt somit die gewünschte Ausgangsgröße dar.

**3. Blockschaltbild**

Fig. 2a:

Hier wird die vorhin genannte Grundidee schaltungsmäßig realisiert :

Die Brücke wird von einem symmetrischen ( Pulsdauer = Pausendauer ) RechteckOszillator versorgt.

An den Punkten X legt eine vom Ausgang U_out gesteuerte Klemmschaltung, am Punkt Y eine von der Offsetspannung gesteuerte Klemmschaltung den Gleichspannungsanteil fest.

Die Differenzspannung X - Y wird von einem synchronisierten Verstärker im Zeitpunkt (1) mit der Leerlaufverstärkung verstärkt. Im Zeitpunkt (0) darf der Verstärker nicht aktiv sein, es wird daher der Ausgang des Verstärkers in dieser Phase auf einen konstanten Wert gehalten.

Der darauf folgende Integralregler hat eine größere Zeitkonstante als die Periode des Clocksignals. Die Phase des Ausgangssignal wird so gewählt, daß eine Gegenkopplung zum Meßpunkt X zum Zeitpunkt (1) besteht.

Die Referenzgröße für den Integralregler ist eine konstante Spannung. Der Ausgang des Synchron-Verstärkers zum Zeitpunkt (1) beträgt im Schnitt UB/2.

Wenn für den Zeitpunkt (0)

a) 0 Volt
b) letzter Wert ( = UB/2 im statistischen Mittel )
c) UB

gewählt wird, dann ergeben sich folgende Referenzspannungen :

a) 1/4 UB
b) 1/2 UB
c) 3/4 UB.

**4. Realisierungsmöglichkeiten für den Synchronverstärker**

Theoretisch kann der Synchronverstärker auf folgende Arten realisiert werden :

a) Differenzverstärker:
Nur für sehr niedere Clockfrequenzen ( bis ca. 10 kHz ) geeignet. Um bei einer hohen Clockfrequenz von z.B. 1MHz und einer geforderten Verstärkung von mindestens 1000 ein Rechtecksignal noch gut wiedergeben zu können, ist ein Gewinn-Bandbreite-Produkt (=GBP) von > 10 GHz notwendig. Standardmäßige Operationsverstärker haben ein GBP von max. 1 GHz. Die Synchronisation erfolgt durch eine zusätzliche Beschaltung des Ausgangssignals, z.B. ein Transistor schließt das Ausgangssignal nach einem Serienwiderstand kurz.

b) Sample-Hold :
Hier gilt das Gleiche wie für a). Der Sample-Hold Baustein hat nur den Vorteil einer einfacheren Synchronisierung.

c) Pulsbreitenmodulation :
Das Ausgangsignal wird als Puls-Pausen-Verhältnis ausgegeben. In Fig. 3 wird die Äquivalenz zwischen Differenzverstärker und Pulsbreitenmodulator veranschaulicht. Wie im nächsten Punkt gezeigt wird, kann der Pulsbreitenmodulator auf besonders einfache Weise realisiert werden.

In Fig. 3 werden die Spannungsdiagramme für i) Differenzverstärker / Sample-Hold und ii) Pulsbreitenmodulator gezeigt. Bei sehr hohen Clockfrequenzen verändert sich der Rechteckimpuls durch die begrenzte Flankensteilheit zu einem Dreiecksimpuls iii).

**5. Realisierungsmöglichkeiten synchron. Pulsbreitenmodulator**

Anforderungen:

- hohe Verstärkung (> 1000 )
- hohe Geschwindigkeit ( Periodendauer < 1μs)
- hohe Temperaturstabilität

Nicht gefordert : Linearität, da durch die Regelung ein konstanter Arbeitspunkt vorliegt.

Möglichkeiten :

Es gibt eine große Anzahl von Präzisions-Komparatoren, die in Analog-Digitalwandlern nach sukzessiver Approximation oder Sigma-Delta-Verfahren angewendet werden. Es gelten dort die gleichen hohen Anforderungen. Durch die hohe Stückzahl sind dies sehr preiswerte und übliche Bauteile.

Pulsbreitenmodulation durch Antwortzeit ( response time ) eines Komparators : Fig. 4a:

Die Antwortzeit ist abhängig von der Übersteuerung ( overdrive ) der Eingänge. Es tritt sowohl eine positive als auch eine negative Übersteuerung auf. Die dazugehörigen Antwortzeiten können durchaus verschieden sein. Für die Realisierung wird die Betriebsart mit der kürzeren Antwortzeit gewählt, da man damit eine höhere Grenzfrequenz bzw. eine kleinere Übersteuerung und damit verbunden eine bessere Genauigkeit erreicht. Die Betriebsart mit der kürzeren Antwortzeit ergibt den stabileren Arbeitspunkt.

Synchronisation des Komparators :

Während der Low-Phase des Clock-Signals soll der Komparatorausgang nicht reagieren bzw. konstant sein, z.B. durch Schalten des Ausgangs auf Masse.

Komparator mit Open-Collector-Ausgang :

Der Ausgang wird über einen Pull-up-Widerstand mit dem Clocksignal verbunden. Der Komparator kann dadurch nur in der High-Phase des Clocksignals reagieren, in der Low-Phase ist der Ausgang auf Masse. Für sehr schnelle Anwendungen ist eine zum Pull-up-Widerstand parallel und in Sperrichtung zum Clocksignal geschaltene Schottky-Diode von Vorteil.

Komparator mit Spannungs-Ausgang :

Der Spannungsausgang kann durch einen nachfolgenden schnellen Schalttransistor in einen Open Collector Ausgang umgewandelt werden.

Komparator mit Latch-(oder Inhibit-)Eingang:

Der Ausgangszustand des Komparators wird während der Low-Phase des Taktsignals durch einen geeigneten Eingang eingefroren. Meist weisen derartige Komparatoren einen Spannungsausgang auf. Ein nachfolgender schneller Schalttransistor ist möglicherweise trotzdem empfehlenswert, da der Spannungsausgang üblicherweise nur zum Ansteuern von digitalen Eingängen ausgelegt ist und unter Umständen die Sättigungsspannung über den Temperaturbereich beträchtlich schwankt.

**6. Realisierung einer Gesamtschaltung ( Beispiel )**

Fig. 8 :

Das Blockschaltbild nach Fig. 2b wird hier zu einer konkreten Schaltung umgesetzt.

6.1 Brücke :

C1, C2 :    Meßkondensatoren
C3, C4 :    Referenzkondensatoren

**6.2 Synchronverstärker** :

Aufgebaut als synchronisierter Pulsbreitenmodulator. Die Modulation erfolgt über die Kennlinie response time zu input overdrive eines schnellen Präzisionskomparators. Es wird hier die positive Übersteuerung als Arbeitspunkt benutzt, da sie die kleinere response time aufweist. Die Auswahl ergibt sich ohne weitere Bauteile von selbst, da sich die Schaltung auf Grund der schnelleren Reaktionszeit auf diesen Punkt hin regelt. Der Komparator hat einen Open-Collector-Ausgang. Die Synchronisierung erfolgt über den Pull-up-Widerstand R8,

**6.3 Integralregler :**

Sollwert : UB/4, da der Ausgang der vorhergehenden Stufe in der Low-Phase des Clock-Signals auf Masse liegt und in der High-Phase UB/2 im Mittel gewählt wurde.
Istwert : Das Ausgangssignal der vorhergehenden Stufe ( Komparatorausgang ).
Rückkopplung :Der Spannungsteiler R1, R2 sowie die Klemmschaltung D1, R5. Mit R2 wird die Verstärkung eingestellt.
Stellglied : Der Synchronverstärker, hier realisiert durch einen Komparator.
Zeitkonstante für Integralregler: R9, C5. Sie soll größer als die Periodendauer des Clocksignals sein.

**6.4 Integralregler :** Operationsverstärker ( OpAmp ).

'Störgröße': Der sich ändernde Kapazitätswert in der Brücke. Dies ist die eigentliche Meßgröße.
Der Ausgang des Integralreglers stellt bereits das Meßsignal dar. Bei sehr schnellen Anwendungen wird man das Verhältnis Integrationszeitkonstante zu Periodendauer relativ klein ( zwischen 1 und 10 ) wählen, um auch eine hohe Meßfrequenz erzielen zu können. Dies hat dann eine relativ große Welligkeit am Ausgang des Integrators zur Folge. Es wird daher noch ein mehrpoliges aktives Filter nachgeschaltet, mit dem dieser Trägerrest beseitigt wird und das dennoch eine hohe Meßfrequenz erlaubt.
Bei sehr langsamen Anwendungen kann die Integrationszeitkonstante sehr groß gewählt werden, die Welligkeit ist entsprechend gering und man kann auf eine folgende Filterstufe auch verzichten.

**6.5 Gegenkopplung**

Der Synchronverstärker wird mit der Leerlaufverstärkung betrieben, und der Integralregler hat keinen Proportionalanteil. Die Verstärkung v wird allein von der Gegenkopplung, das ist hier der Spannungsteiler R1, R2 , bestimmt:

$$v = \frac{U_{out}}{U_X - U_Y} = 1 + \frac{R2}{R1}$$

Wenn nur C1 verändert wird :

$$C1 = C + \Delta C, \qquad C2, C3, C4 = C$$

$$U_X - U_Y \approx UB \, \frac{-\Delta C}{4C}$$

Wenn C1 und C2 verändert wird (Differentialkondensator):

$$C1 = C + \Delta C, \quad C2 = C - \Delta C, \qquad C3, C4 = C$$

$$U_X - U_Y \approx UB \, \frac{-\Delta C}{2C}$$

Die Offseteinstellung braucht nicht über Trimmkondensatoren zu erfolgen, sondern wird über eine Spannung am Eingang 'Offset' durchgeführt.

Lineare Messung des Plattenabstandes eines Plattenkondensators :

Gegeben sei eine Halbbrücke mit dem Meßkondensator C1 und dem Referenzkondensator C3. Der Meßkondensator C1 läßt sich als physikalisches Modell in eine konstante Parallelkapazität Cp und eine sich mit dem Plattenabstand $\Delta d$ sich ändernden Plattenkondensator C0 aufteilen.

$\Delta d :=$ Abstand von der Ruhelage
$d_0 :=$ Abstand in Ruhelage
$C_0 :=$ Kapazitätswert des Plattenkondensators bei $d_0$
$Cp :=$ Parallelkapazität
$s :=$ $1 + \Delta d / d_0$

s gibt somit ein Abstandsmaß zur Ruhlage an und ist linear zu $\Delta d$. Es gilt

$$C1 = Cp + C0/s.$$

Es erfolgt eine Gegenkopplung vom Ausgang $u_A$ zum Steuereingangeingang der Spannnungsamplitude des Brückenzweig des Meßkondensators.

w := Faktor für Größe des Spannungshubs im Brückenzweig ($0 \le w \le 1$).

Es ist nun eine zu $\Delta d$ bzw. zu s lineare Ausgangsgröße gewünscht.

Behauptung : Durch geeignete Rückkopplung der Ausgangsspannung y an den Kompensationseingang läßt sich ein zu s vollkommen lineares Ausgangssignal erreichen. Die Linearitätsabstimmung ist dabei unabhängig vom Nullpunkt.

Beweis:

Die Gleichung (2) wird dadurch folgenderweise verändert :

$$(3) \qquad u_A = v \, u_B \left( \frac{1}{n} - w \frac{C3}{C1 + C3} \right)$$

Rückkopplungsfaktor $u_A$ nach $u_C$ betrage k .

$$(4) \qquad k := \frac{u_A}{u_C}$$

$$k = 1 + R7/R10.$$

Die Verstärkungskorrektur w beträgt dann

$$(5) \qquad w = 1 - u_C / u_B = 1 - \frac{u_A}{k u_B}$$

$$(6) \qquad \Rightarrow u_A - u_B \, v \left( \frac{1}{n} - \left( 1 - \frac{u_A}{k u_B} \right) \frac{C3}{C1 + C3} \right)$$

Der Kondensator C1 wird nun durch das physikal. Modell Cp + C0 / s ersetzt:

$$(7) \qquad u_A = u_B \, v \left( \frac{1}{n} - \left( 1 - \frac{u_A}{k u_B} \right) \frac{C3}{Cp + C0/s + C3} \right)$$

Diese für $u_A$ implizite Gleichung läßt sich in die folgende explizite umformen :

$$(8) \qquad u_A = k \, u_B \, v \, \frac{s \, (Cp + (1 + n) \, C3) + C0}{s \, n \, (k \, Cp + (k - v) \, C3) + k \, n \, C0}$$

Damit $u_A$ linear zu s ist, muß der s-Term im Nenner null werden :

$$(9) \qquad \Rightarrow k \, Cp + (k - v) \, C3 = 0$$

Es gilt somit folgende Linearitätsbedingung für k :

$$(10) \qquad k = v \, \frac{C3}{Cp + C3}$$

Die Linearitätsbedingung ist somit unabhängig von der Mittenabstimmung m. die Wenn die Linearitätsbedingung mit einer Einstellung k für jedes v gelten soll, dann muß k proportional zu jedem v sein.

Dies kann durch eine der folgenden Maßnahmen erreicht werden :

a) es gibt nur ein v $\Rightarrow$ v ist konstant, d. h. die Verstärkung wird fest in Form von Fixwiderständen vorgegeben $\Rightarrow$ es gibt nur ein k $\Rightarrow$ k ist konstant.
b) v ist variabel : Die Linearität wird bei einem beliebigen v über einen Widerstand abgeglichen. Die Bedingung (10), daß k und v zueinander direkt proportional sind kann in Form eines Tandem-Potentiometers auf einfache Weise und mit hoher Genauigkeit erfüllt werden.

Die Gleichung (7) ändert sich unter der Bedingung (10) auf:

$$(11) \qquad u_A = u_B \cdot v \left( s \frac{(n+1)\,C3 + Cp}{nC0} + \frac{1}{n} \right)$$

Das Ausgangssignal $u_A$ ist somit linear zum Abstandsmaß s.

Ende des Beweises.

### 6.6 Klemmschaltung

Aufgebaut durch :

Positiver Komparatoreingang : D1, R5, C1, C3.
Negativer Komparatoreingang : D2, R6, C2, C4.

Die Dioden D1, D2 sind vorzugsweise als eine Doppeldiode in einem Gehäuse ausgeführt. Dies hat den Vorteil, daß bei Temperaturschwankungen die Nullpunktsdrift minimiert wird. Da die Brückenkapazitätswerte sehr gering sind, kann bei gewöhnlichen Dioden der Sperrstrom über die Temperatur bereits zu großen Nullpunkts- und Verstärkungsänderungen führen. Es wird daher die Verwendung von FET-Dioden empfohlen, die einen spezifizierten Sperrstrom von bis zu kleiner als 1pA bei Raumtemperatur aufweisen. Damit läßt sich ein extrem gutes Temperaturverhalten erreichen.

Die Dioden D1, D2 werden jeweils von R5, R6 überbrückt. R5, R6 sind relativ hochohmig (ca. 100 kΩ); die Zeitkonstante R5, C1 + C3 bzw. R6, C2 + C4 ist somit wesentlich größer als die Periodendauer des Clocksignals. Mit den Überbrückungswiderständen weist die Schaltung einen wesentlich verbesserten Frequenzgang auf.

D1, D2 könnten auch zur Gänze entfallen. Die Überbrückungswiderstände müssen dann auf einen kleineren Wert dimensioniert werden. Dies ist notwendig, um eine hohe Grenzfrequenz erreichen zu können und um zu verhindern, daß die Phasendrehung des Integrators und die Phasendrehung des RC-Glieds R5* (C1+C3) zusammen -180° beträgt, da sonst aus der Gegenkopplung eine Mitkopplung wird, und die Schaltung schwingt. Durch den kleineren Wert von R5, R6 wird die Kapazitätsbrücke bereits deutlich entladen; die Rechteckspannung in den Punkten X, Y verändert sich von einem Rechteck zu einem fallenden Trapez. Bei gleichen Werten der Gegenkopplung R1, R2 veringert sich die Verstärkung um den Faktor 2, da nun die Gegenkopplung nicht nur in der High-Phase des Clocksignals aktiv ist, sondern auch in der Low-Phase. Ohne die Dioden D1, D2 ist die Schaltung zwar einfacher, man verliert aber durch die fallende Flanke relativ viel an Temperaturstabilität der Gesamtschaltung.

### 6.7 Rechteckoszillator

Anforderungen :

- Das Puls-Pausen Verhältnis soll ungefähr 1:1 sein und muß präzise konstant bleiben.

- hohe Flankensteilheit
- Ausgangspegel von Masse bis +UB. Die Sättigungsspannung soll relativ gering sein und darf sich über die Temperatur auch nicht nennenswert ändern.

Nicht gefordert : Konstante Frequenz.

### 7. Quasistatische Anwendungen

Fig. 5 :

Die bis jetzt beschriebene Anwendung ist auch echt statisch, das heißt, es kann auch ein konstant gleichbleibender Meßkondensator C1 gemessen werden. Es gibt aber sehr schwierige Anwendungsfälle, wo sich C1 langsam, aber wesentlich größer als das Meßsignal ändert und C2 nicht oder nur ungenügend als Referenzwert verwenden läßt. In solchen Fällen begnügt man sich mit einer sehr niedrigen unteren Grenzfrequenz.

Eine quasistatische Variante der Schaltung kann dadurch erreicht werden, indem das Ausgangssignal von ein Integralregler an den Offset-Eingang zurückgeführt wird. Gegenüber einer einfacheren AC-Auskopplung hat dies den Vorteil, daß der Eingang nicht so leicht übersteuert werden kann, da er in der Regelschleife liegt. Damit läßt sich in weiterer Folge eine bessere Auflösung erzielen.

Bei der quasistatischen Ausführung kann man auch einen Brückenzweig völlig weglassen. Der Offset-Eingang befindet sich dann direkt am Komparator.

### 8. Eigenschaften der Gesamtschaltung

### 8.1 Geschwindigkeit:

Das Schaltungskonzept wurde so ausgelegt, daß sich eine hohe Meßfrequenz erreichen läßt. Dafür verantwortlich sind :

- Hohe Clockfrequenz
- Schnelle Pulsbreitenmodulation mittels response time eines schnellen Komparators.
- Die Zeitkonstante des Integralreglers ist relativ klein. Die dadurch in Kauf genommene Welligkeit wird durch ein aktives Tiefpaßfilter mit relativ hoher Grenzfrequenz eliminiert.
- Die Dioden in der Klemmschaltung werden mit Widerständen überbrückt.

Mit diesen Maßnahmen ist z.B. bei einem Komparator mit 100ns response time eine Grenzfrequenz von 100 kHz erreichbar.

### 8.2 Hohe Auflösung :

Trotz der hohen Geschwindigkeit hat die Schaltung eine sehr hohe Auflösung. Wenn nur eine niedrige Grenzfrequenz gewünscht wird, dann reicht es aus, die letzte Ausgangsstufe auf diese Grenzfrequenz zu dimensionieren. Die Clock-Frequenz soll nicht verändert werden, da die response time des Komparators nicht beliebig verlängert werden kann.

Bei einer sorgfältigen Auslegung des Layout's ist eine Auflösung von 12 bit bei 100 kHz Grenzfrequenz ohne weiteres möglich. Bei einer tieferen Grenzfrequenz ergibt sich eine entsprechend weitere höhere Auflösung.

Getroffene Maßnahmen für eine hohe Auflösung :

- Wheatstone-Brücke mit gleich großen Brückenelementen.
- Die Brücke wird mit dem vollen Aussteuerbereich, das ist zwischen Masse und +UB, gespeist.
- Die Eingangsstufe, das ist der Komparator, hat eine Verstärkung von > 1000.
- Der folgende Operationsverstärker hat bei der betriebenen Frequenz noch eine Verstärkung von 100.
- Komparator und Operationsverstärker werden zusammen im Open Loop betrieben. Die Open Loop Gesamtverstärkung ist das Produkt der beiden Komponenten ( hier: 100000). Die tatsächliche Verstärkung wird nur durch die Gegenkopplung R1, R2 ( Fig.8) bestimmt.
- Niederer Eingangswiderstand, dadurch auch geringes Rauschen. Der kapazitive Eingangswiderstand liegt je nach Kapazitätwert der Brücke und Clock-Frequenz zwischen 1 kΩ -10 kΩ.
- Durch das aktive Filter wird die Grenzfrequenz auf den gewünschten Wert herabgesetzt, was ebenfalls der Auflösung zugute kommt.
- Die Versorgung für den Komparator erfolgt über einen zusätzlichen RC-Tiefpaß.

Die Auflösung könnte zusätzlich noch um den Faktor 2 erhöht werden, indem die Brücke mit C1, C2 nicht auf Masse geht, sondern mit einem genau gegenphasigen Clock-Signal verbunden wird.

### 8.3 Gute Temperaturstabilität:

Die Schaltung wurde für eine extrem hohe Temperaturstabilität konzipiert. Bei den meisten Anwendungsfällen ist der Temperaturkoeffizient der Schaltung wesentlich geringer als der des Meßkondensators.

Maßnahmen für eine hohe Temperaturstabilität:

- Die Brückenreferenzkondensatoren sollen einen möglichst kleinen Temperaturkoeffizienten aufweisen.

- Der Arbeitspunkt des Komparators in der Eingangsstufe wird so gewählt, daß sich eine kleine overdrive-Spannung ( < 5 mV ) ergibt. Bei der Auswahl des Komparators ist darauf zu achten, daß sich die response time bei der gewählten overdrive-Spannung über die Temperatur sich relativ wenig ändert. Die Temperaturabhängigkeit der Eingangsstufe wird dann im wesentlichen durch die Formel

$$\text{TK}_{\text{Eingangsstufe}} \, [\text{mV} / ^\circ \text{C}] = \frac{\Delta \text{overdrive}}{\Delta T} \, \text{Verstärkung}$$

bestimmt. Die Verstärkung ergibt sich aus ( 1 + R2 / R1 ).

- Die Offsetspannungsänderung des folgenden Operationsverstärkers hat praktisch keinen Einfluß, da diese Größe mit dem Faktor der Leerlaufverstärkung der ersten Stufe ( > 1000 ) dividiert wird.

- Die Offsetspannungsänderung des Operationsverstärkers im aktiven Filter geht nur mit dem Faktor 1 ein und kann somit vernachläßigt werden.

- Die Brücke wird in der High-Phase des Clocks durch den Sperrstrom der Klemmdioden D1, D2 teilweise entladen.
  Dies hat folgenden Einfluß auf Verstärkung und Nullpunkt:

$$\text{Gain TK}_{\text{Diode R}} \, [\%0/^\circ\text{C}] = \frac{1000 * \Delta \, \text{Ir} * t}{Cp * \Delta T}$$

$$\text{Offset TK}_{\text{Diode R}} \, [\%0/^\circ\text{C}] = \frac{1000 * \Delta \, (\text{Ir1-Ir2}) * t}{Cp * \Delta T}$$

wobei

$\Delta$ Ir :    Sperrstromänderung über die Temperaturänderung $\triangle$ T

Cp :    C1 + C3 bzw. C2 + C4

t :    Halbe Periodendauer des Clock-Signals

Mit üblichen Silizium - Universaldioden kommt man hier auf einen temperaturabhängigen Verstärkungskoeffizienten, der bereits in der Nähe von 1 Promill / °C ist. Bei großem Temperaraturbereich ( z.B. 100°C) und hoher Verstärkung ( ca. 100 ) läuft man bei der Drift bereits Gefahr, außerhalb des Meßbereichs zu kommen.

Es gibt FET-Dioden die ca. einen um den Faktor 100 bis 1000 kleineren Sperrstrom haben. Bei Einsatz eines solchen Typs erreicht man selbst bei hoher Verstärkung und großem Temperaturbereich einen Driftbereich in Größenordnungen von wenigen Promill. Es ist von Vorteil, wenn D1, D2 als eine Dualdiode ausgeführt ist, da dadurch beide Dioden dieselbe Umgebungstemperatur haben. Für eine quasistatische Ausführung genügt eine Silizium-Diode, da hier die Offsetspannung nachgeregelt wird.

- Die Dioden sollen vorzugsweise als Dualdiode ausgeführt sein. Einzeldioden sollen thermisch gekoppelt werden und eine möglichst gleiche Durchlaßkennlinie aufweisen.
Während der Low-Zeit des Clock-Impulses sind die Dioden leitend. Die Durchlaßspannung $U_F$ ist temperaturabhängig. Es entsteht dabei folgender Offsetfehler:

$$\text{Offset TK}_{\text{Diode F}} \text{ [mV/}^\circ\text{C]} = \frac{\Delta U_{F1} - \Delta U_{F2}}{\Delta T} \text{ Verstärkung}$$

Diese Offsetspannung ist linear mit der Temperatur und kann somit relativ leicht kompensiert werden. Bei extrem hohen Anforderungen kann man die Dioden auch auf konstante Temperatur halten.
Prinzipiell kann man die Dioden ebenso durch Schaltemente ersetzen. In der High-Phase ist dann der Zustand AUS und in der Low-Phase der Zustand EIN.

- Rechteckoszillator mit geregeltem Puls-Pausen-Verhältnis. Eine Änderung dieses Wertes geht direkt proportional ins Meßergebnis ein. Bei der Ausführung mit einem Komparator ändert sich der Umschaltpunkt nur um soviel, wie sich die Offsetspannung über die Temperatur ändert. Bei Einsatz eines Präzisionskomparators kann dieser Wert vernachlässigt werden.

### 8.4 Geringe Störempfindlichkeit

Tests haben gezeigt, daß die Störfestigkeit erstaunlich hoch ist. Neben den üblichen Entstörmaßnahmen ist dies auf folgende Gründe zurückzuführen :

- Niederer Innenwiderstand des Rechteckoszillators.
- Durch die hohe Clockfrequenz ergibt sich auch ein niederer kapazitiver Eingangswiderstand für die Schaltung.
- Niederer Innenwiderstand der Rückkopplung durch niederohmigen Widerstand R1, R3.
- Der Komparator in der Eingangsstufe reagiert praktisch auf einen Mittelwert während der response time.
- Die Eingangsstufe kann nicht übersteuert werden, da sie als Pulsbreitenmodulator arbeitet.
- Die Störungen werden durch den nachfolgenden Integrator gedämpft.
- Das aktive Tiefpaßfilter filtert Störfrequenzen, die über der Meßfrequenz liegen, wirkungsvoll aus.

### Verfahren zum Messen kleiner Kapazitäten oder Kapazitätsänderungen

Das Verfahren arbeitet mit einer 2-Phasenmethode. Das Grundprinzip basiert darauf, den Gleichspannungsanteil mindestens einer Brückenspannung (X, Y) in einer zweiten Phase so nachzuregeln, daß in einer ersten Phase die Brückendifferenzspannung null, bzw. exakter einen konstant sehr kleinen Wert ε aufweist. Die Regelspannung ist dann das Maß für die Brückenverstimmung. Der Regler ist vorzugsweise ein Integralregler.

Die Brückendifferenzspannung wird dabei in einer ersten Phase von einem Pulsbreitenmodulator mit sehr hoher Empfindlichkeit erfaßt und als Pulsbreite abgebildet. Dieses Signal wird dann an den Integrator weitergegeben. Die Ausgangsspannung des Integrators stellt über eine Gegenkopplung in einer zweiten Phase unter Änderung des Gleichspannungsanteils mindestens einer Brückenspannung (X, Y) das Brückengleichgewicht (X = Y - ε) für die erste Phase her.
Für den Pulsbreitenmodulator ergibt sich eine besonders vorteilhafte Realisierung dadurch, daß ein Komparator zum Einsatz kommt, wobei als Eingangsgröße die Übersteuerungsspannung ΔU und als Ausgangsgröße die Antwortzeit Δt dient. Der Arbeitspunkt (ΔU, Δt ) wird dabei günstigerweise so festgelegt, daß Δt gleich der halben Intervallzeit der ersten Taktphase ist und ΔU einen noch ausreichend kleinen Wert darstellt. Ein kleiner ΔU - Wert hat den Vorteil, daß sich Änderungen in der Ansprechzeit des Komparators über die Temperatur nur geringfügig auf ΔU und somit auf die Meßgenauigkeit auswirken. Da die Ansprechzeit schneller Komparatoren im ns-Bereich liegt, kann bei dieser Realisierung eine sehr hohe Taktfrequenz und in weiterer Folge eine sehr hohe Meßfrequenz erreicht werden.

Der Pulsbreitenmodulator soll in einer zweiten Taktphase kein Signal liefern. Dies kann dadurch erreicht werden, daß entweder die Eingänge oder der Ausgang auf inaktiv geschaltet werden oder auch daß der Ausgang während dieser Zeit auf ein konstantes Potential, vorzugsweise Masse, geschaltet wird.

Das Brückengleichgewicht (X = Y - ε) wird in einer ersten Phase dadurch hergestellt, daß ein Teil der Integratorspannung über eine Gegenkopplung (G) an an mindestens eine Brückenspannung, das ist an die Brückenspannung X oder invertiert an die Brückenspannung Y zurückgeführt wird und daß eine konstante Gleichspannung N mindestens einer Brückenspannung (X, Y) überlagert wird, wobei die Beziehung gilt : $N_x + N_y$ = konstant = vorzugsweise U_Batterie.

Bei einer Vollbrücke ist dann im einfachsten Fall der eine Brückenzweig mit der Gegenkopplung und der andere mit dem Abgleich verbunden. Bei Anwendungen, wo der Meßkondensator keinen Gleichspannungsanteil aufweisen darf, schaltet man einen Kondensator mit theoretisch ∞, in der Praxis mit dem mindestens 100-fachen Wert der Meßkapazität in Serie zum Meßkondensator.

Bei einer Halbbrücke ist der Brückenzweig mit der Gegenkopplung und der Abgleich mit dem zweiten Eingang des Pulsbreitenmodulators verbunden. Unter Beachtung der Gegenkopplungsbedingung ist auch der umgekehrte Fall möglich : Der Brückenzweig wird mit dem Abgleich und der zweite Eingang mit der Gegenkopplung verbunden. Die erste Methode hat den Vorteil, daß die Spannungen (X, Y) in einer ersten Phase konstant bleiben und dadurch nur geringe Anforderungen an die Gleichtaktunterdrückung des Pulsbreiten-modulators bestehen. Bei einer Vollbrücke gilt analog dies ebenso.

Es gibt Anwendungen, wo eine statische Messung z.B. infolge von großen Temperatureinflüssen nicht sinnvoll ist und ein automatischer Nullpunktsabgleich bevorzugt wird. Dies wird erfindungsgemäß dadurch erreicht, indem ein zweiter Integralregler mit großer Integrationszeitkonstante in Abhängigkeit vom Integrationsergebnis des ersten Integralreglers auf einen konstanten Referenzwert regelt. Die Stellgröße des zweiten Integralreglers wird mit dem Eingang 'Offset' verbunden.

Bei einem anderen Anwendungsfall wird ein bestimmter Verstärkungs-Temperaturkoeffizient gewünscht um z.B. den der Mechanik zu kompensieren. Dies wird erfindungsgemäß dadurch erreicht, daß die Spannungsamplitude des Taktsignals in mindestens einem Brückenzweig von einer temperaturabhängigen Spannung gesteuert wird. Die Steuerung der Amplitude in beiden Brückenzweigen ist dabei vorzuziehen, weil dadurch keine Nullpunktsänderungen entstehen. Die Änderung der Spannungsamplitude kann dabei auf einfache Weise durch eine Hubbegrenzung des Taktsignals ausgeführt sein.

Bei einem weiteren Anwendungsfall soll die Ausgangsgröße linear zum Normalabstand eines Plattenkondensators sein. Dies kann dann erreicht werden, wenn man in linearer Abhängigkeit vom Integrationsergebnis die Amplitude der vom Taktsignal abgeleiteten Spannung des Brückenzweiges verringert, in dem sich auch der Meßkondensator befindet. Mit dieser Methode läßt sich eine perfekte Linearisierung des ansonsten hyperbelförmigen Verlaufs erreichen.

Die Umsetzung von Kapazität auf Spannung läßt sich auf folgende Formel zurückführen:

Bei einer Vollbrücke ( 2 Brückenzweige):

$$(1) \qquad u_A = v\, u_B \left( \frac{C4}{C2 + C4} - \frac{C3}{C1 + C3} + \frac{1}{n} \right)$$

wobei C1, C2 auf einer Seite mit Masse und C3, C4 mit einer Seite mit der Brückenspeisung verbunden sind. C1 bildet mit C3 den 1. Brückenzweig, C2 mit C4 den 2. Brückenzweig.

Bei einer Halbbrücke ( nur 1. Brückenzweig ):

$$(2) \qquad u_A = v\, u_B \left( \frac{1}{n} - \frac{C3}{C1 + C3} \right)$$

wobei

| | | |
|---|---|---|
| $v :=$ | | Verstärkungsfaktor |
| $n :=$ | | Faktor für die Nullpunktseinstellung |
| $u_A :=$ | | Ausgangsspannung |
| $u_B :=$ | | Spannungshub Brückenspeisung |

Die beiden Kompensationen für Temperatur und Linearität schließen sich gegenseitig nicht aus und können daher auch gleichzeitig angewandt werden.

Das Taktsignal soll ein festes Taktverhältnis aufweisen, da das Tastverhältnis über die Integration in das Meßergebnis eingeht. Das günstigste Tastverhältnis ist 1 : 1, da beide Taktphasen die annähernd gleichen Einschwingzeiten benötigen.

Die Gegenkopplung (G) kann den Gleichspannungsanteil entweder in beiden Taktphasen über einen Widerstand in die Brückenspannung (X) oder invertiert in (Y) einkoppeln, oder es wird nur in einer zweiten Phase über eine Klemmschaltung oder einen Analogschalter eingekoppelt. Im ersten Fall ist bei gleicher Gegenkopplung (G) die Verstärkung um den Faktor 2 - bei symmetrischem Tastverhältnis des Taktsignals - kleiner. Der zweite Fall ist zum Erreichen einer hohen Meßfrequenz günstiger, da man im ersten Fall relativ hochohmig einkoppeln muß, damit die Meßbrücke nicht zu sehr entladen wird und sich dadurch auch große Zeitkonstanten ergeben. Die höchste Meßfrequenz wird mit einer Dioden-Klemmschaltung ermöglicht.

Zum Erreichen einer sehr hohen Meßfrequenz ist es auch sehr vorteilhaft die Integrationszeitkonstante relativ klein ( 1 .. 10 - fache der Taktperiode) zu wählen und dafür eine größere Welligkeit des Integratorausgangs in Kauf zu nehmen. Diese Welligkeit kann sehr leicht durch Nachschalten eines steilen Tiefpaßfilters, dimensioniert auf die gewünschte Meßfrequenz, beseitigt werden.

**Patentansprüche**

**1.** Verfahren zum Messen kleiner Kapazitäten mit einer selbstabgleichenden Brückenschaltung (A), wobei die Kapazität oder die Kapazitätsänderung eines unbekannten Kondensators (C1) in einem Brückenzweig bzw. die Kapazitäten oder die Kapazitätsänderung zweier unbekannter Kondensatoren (C1, C2) in zwei verschiedenen Brückenzweigen bestimmt wird und die aus Referenzkondensatoren (C2, C3, C4 bzw. C3, C4) und einem unbekannten Kondensator (C1) oder unbekannten Kondensatoren (C1, C2) gebildete Brücke (A) an zwei ersten Diagonalpunkten mit einer periodischen, im wesentlichen rechteckförmigen Spannung (T) mit konstanter Amplitude gespeist wird, wobei die Recht-

EP 0 745 861 B1

eckspannung (T) in einer Periode jeweils von einem ersten (T(0)) auf einen zweiten Pegel (T(1)) wechselt, **dadurch gekennzeichnet, daß** fortlaufend nur während des zweiten Pegels (T(1)) des Rechtecksignals die Spannungsdifferenz an zwei zweiten Diagonalpunkten (X, Y) der Brücke in einem Synchronverstärker (D), vorzugsweise einem Komparator, leerlaufverstärkt wird, und während des ersten Pegels (T(0)) der Synchronverstärker (D) ein vorbestimmtes Potential abgibt, sodann das leerlaufverstärkte Ausgangssignals des Synchronverstärkers mittels eines Reglers, vorzugsweise eines Integralreglers (E), auf einen Sollwert geregelt wird, welcher Sollwert durch den Zeitmittelwert der Ausgangsspannung des Synchronverstärkers bei abgeglichener Brücke festgelegt ist, daß mittels der Ausgangspannung des Reglers (E) über einen Gegenkopplungszweig (G) und eine abgleichbare Klemmschaltung (C) die Brücke (A) an den zweiten Diagonalpunkten (X, Y) in Abgleich gebracht wird, wobei die Ausgangsspannung (UA) des Reglers (E) im wesentlichen proportional der Kapazität oder der Kapazitätsänderung des unbekannten Kondensators (C1) bzw. der unbekannten Kondensatoren (C1, C2) ist.

2. Verfahren nach Anspruch 1, **dadurch gekennzeichnet, daß** die integrierte Spannung mit einem Tiefpaß-Filter (F) geglättet wird, wobei die geglättete Ausgangsspannung (U_out) proportional der Kapazität oder der Kapazitätsänderung des unbekannten Kondensators (C1) bzw. der unbekannten Kondensatoren (C1, C2) ist.

3. Verfahren nach Anspruch 2, **dadurch gekennzeichnet, daß** zur quasistatischen Kapazitätsmessung die geglättete Ausgangsspannung in einem weiteren Integralregler in bezug auf einen weiteren Sollwert integriert und diese integrierte Spannung einem dem Abgleich dienenden Eingang (Offset) der Klemmschaltung zugeführt wird, wobei die geglättete Ausgangsspannung proportional der Kapazität oder der Kapazitätsänderung des unbekannten Kondensators (C1) bzw. der Kapazitätsdifferenz oder deren Änderung der unbekannten Kondensatoren (C1, C2) ist.

4. Schaltungsanordnung zur Durchführung des Verfahrens nach Anspruch 1, wobei eine aus Referenzkondensatoren (C2, C3, C4 bzw. C3, C4) und einer oder zwei unbekannten Kapazitäten (C1 bzw. C1, C2) gebildete Brückenschaltung (A) an den zwei ersten Diagonalpunkten mit einem Rechteckgenerator (B) verbunden ist, der eine konstante im wesentlichen rechteckförmige Rechteckausgangsspannung (T) liefert, **dadurch gekennzeichnet, daß** die zwei zweiten Diagonalpunkte (X, Y) mit den Eingängen eines Synchronverstärkers (D) verbunden sind, welcher die Differenz der an den beiden zweiten Diagonalpunkten (X, Y) gemessenen Potentiale nur während des zweiten Pegels (T(1)) des Rechteckgenerators (B) verstärkt, daß der Ausgang des Synchronverstärkers (D) mit einem ersten Eingang eines Reglers, vorzugsweise eines Integralreglers (E), verbunden und während des ersten Pegels (T(0)) der Rechteckspannung auf einem vorbestimmten Potential gehalten ist, und der Ausgang des Reglers (E) mit dem Eingang einer Gegenkopplungsschaltung (G) verbunden ist, daß deren Ausgang mit einem ersten Eingang einer Klemmschaltung (C) verbunden ist, daß ein zweiter Eingang des Reglers (E) mit einer konstanten Sollspannungsquelle (Ref) verbunden ist und ein erster bzw. zweiter Ausgang der Klemmschaltung (C) mit den beiden zweiten Diagonalpunkten verbunden sind, wobei ein zweiter Eingang (Offset) der Klemmschaltung (C) mit einer Abgleichsspannungsquelle verbunden ist, und daß am Ausgang des Reglers (E) eine dem Wert des unbekannten Kondensators bzw. der unbekannten Kondensatoren oder deren Änderungen proportionale Ausgangsspannung abgreifbar ist.

5. Schaltungsanordnung nach Anspruch 4, **dadurch gekennzeichnet, daß** dem Ausgang des Integralreglers (E) ein Tiefpaß-Filter (F) nachgeschaltet ist.

6. Schaltungsanordnung nach Anspruch 5, **dadurch gekennzeichnet, daß** das Tiefpaß-Filter (F) ein aktives Tiefpaß-Filter ist.

7. Schaltungsanordnung nach Anspruch 6, **dadurch gekennzeichnet, daß** das aktive Tiefpaß-Filter durch ein zweipoliges Filter gebildet ist und an dessen Ausgang ein RC-Tiefpaß (R41, C31) nachgeschaltet ist.

8. Schaltungsanordnung nach Anspruch 6 oder 7, **dadurch gekennzeichnet, daß** das aktive Tiefpaß-Filter (F) durch einen Operationsverstärker mit einer zwischen Ausgang und invertierendem Eingang gekoppelten Parallelschaltung aus einem Kondensator (C21) und einem Widerstand (R31) gebildet ist, und daß der nichtinvertierende Eingang des Operationsverstärkers mit einer konstanten Referenzspannung verbunden ist.

9. Schaltungsanordnung nach Anspruch 6, **dadurch gekennzeichnet, daß** das aktive Tiefpaß-Filter (F) mehrpolig ist.

10. Schaltungsanordnung nach einem der vorhergehenden Ansprüche 4 bis 9, **dadurch gekennzeichnet, daß** der Synchronverstärker (D) aus einem Differenzverstärker gebildet ist, wobei der Ausgang des Differenzverstärkers zur Synchronisation mit einem Widerstand und einem vom Rechtecksignal gesteuerten Schalter in Serie verbunden ist.

11. Schaltungsanordnung nach einem der vorhergehenden Ansprüche 4 bis 10, **dadurch gekennzeichnet, daß** der Synchronverstärker (D) durch eine Abtast- und Halteschaltung gebildet ist.

12. Schaltungsanordnung nach Anspruch 11, **dadurch gekennzeichnet, daß** der Synchronverstärker (D) durch einen Pulsbreitenmodulator gebildet ist und die Pulsmodulation durch die Abhängigkeit der Antwortzeit des Ausgangs eines Differenzverstärkers von der Größe der Spannung am Eingang des Differenzverstärkers erfolgt.

13. Schaltungsanordnung nach Anspruch 12, **dadurch gekennzeichnet, daß** der Pulsbreitenmodulator einen Komparator umfaßt, dessen Eingänge mit den beiden zweiten Diagonalpunkten (X, Y) verbunden sind, wobei die Antwortzeit des Ausgangssignals des Komparators eine Funktion des an seinem Eingang angelegten Spannungswertes ist.

14. Schaltungsanordnung nach Anspruch 13, **daurch gekennzeichnet,** daß der Ausgang des Komparators zur Synchronisation über einen Pull-up-Widerstand (R8) mit dem Ausgang des Rechteckgenerators (B) verbunden ist.

15. Schaltungsanordnung nach Anspruch 13, **dadurch gekennzeichnet, daß** der Komparator einen Latch- oder Inhibit- Eingang aufweist.

16. Schaltungsanordnung nach Anspruch 13 oder 15 **,** **dadurch gekennzeichnet, daß** der Ausgang des Komparators mit einer Basis eines Schalttransistors mit kurzer Schaltzeit verbunden ist, dessen Kollektor einen Open-Collector bildet.

17. Schaltungsanordnung nach einem der vorhergehenden Ansprüche 4 bis 16, **dadurch gekennzeichnet, daß** der Integralregler (E) aus einem Differenzverstärker gebildet ist, bei dem ein Integrierkondensator (C5) zwischen Ausgang und invertierendem Eingang vorgesehen ist, welcher invertierender Eingang über einen Widerstand (R9) den Eingang des Integralreglers bildet und bei dem der nichtinvertierende Eingang mit einer Sollspannungsquelle verbunden ist, wobei die Zeitkonstante des Integralreglers durch das Produkt von Widerstand (R9) und Integrierkondensator (C9) bestimmt ist.

18. Schaltungsanordnung nach Anspruch 17, **dadurch gekennzeichnet, daß** die Zeitkonstante des Integralreglers (E) größer oder gleich der Periode der Ausgangsspannung des Rechteckgenerators (B) ist.

19. Schaltungsanordnung nach Anspruch 17, **dadurch gekennzeichnet, daß** das Verhältnis der Zeitkonstante des Integralreglers zur Periodendauer des Rechtecksignals in einem Bereich zwischen 1 und 10 liegt.

20. Schaltungsanordnung nach Anspruch 17, 18 oder 19, **dadurch gekennzeichnet, daß** die Sollspannungsquelle eine konstante Spannung aufweist, deren Wert ein Viertel des Hochpegels des Rechteckgenerators (B) beträgt.

21. Schaltungsanordnung nach einem der vorhergehenden Ansprüche 4 bis 20, **dadurch gekennzeichnet, daß** die Gegenkopplungsschaltung (G) aus einem ersten mit einem der zweiten Diagonalpunkte verbundenen Gegenkopplungswiderstand (R2) und einem mit diesem verbundenen zweiten Gegenkopplungswiderstand (R1), der an seinem anderen Ende mit Masse verbunden ist, gebildet ist.

22. Schaltungsanordnung nach Anspruch 21, **dadurch gekennzeichnet, daß** die Klemmschaltung (C) über einen ersten Klemmwiderstand (R5) einen der zweiten Diagonalpunkte mit dem Verbindungspunkt zwischen den Gegenkopplungswiderständen (R2, R1) verbindet und über einen zweiten Klemmwiderstand (R6) den andern der zweiten Diagonalpunkte mit dem Abgriffspunkt eines aus Widerständen (R3, R4) gebildeten Spannungsteiler verbindet, wobei eine am zweiten Eingang (Offset) der Klemmschaltung anliegende Abgleichsspannung durch den Spannungsteiler geteilt wird.

23. Schaltungsanordnung nach Anspruch 22, **dadurch gekennzeichnet, daß** zum ersten bzw. zweiten Klemmwiderstand (R5 bzw. R6) eine erste bzw. zweite Klemmdiode (D1 bzw. D2) parallelgeschaltet ist.

24. Schaltungsanordnung nach Anspruch 23, **dadurch gekennzeichnet, daß** die erste und die zweite Klemmdiode (D1, D2) als Doppeldiode in einem Gehäuse angeordnet sind.

25. Schaltungsanordnung nach einem der vorhergehenden Ansprüche 4 bis 24, **dadurch gekennzeichnet, daß** ein weiterer Integralregler zwischen den Ausgang des Tiefpaß-Filters (F) und den zweiten Eingang (Offset) der Klemmschaltung (C) geschaltet ist.

26. Schaltungsanordnung nach einem der vorhergehenden Ansprüche 4 bis 25, **dadurch gekennzeichnet, daß** die Referenzkondensatoren (C3, C4) über je einen Widerstand (R10, R11) mit dem Ausgang des Rechteckgenerators (B) verbunden sind, wobei die Verbindungspunkte zwischen den Referenzkondensatoren (C3,C4) und den Widerständen (R10, R11) über je eine Diode (D5, D4) Kompensationseingänge (Comp_x, Comp_y) bilden.

27. Schaltungsanordnung nach Anspruch 26, **dadurch gekennzeichnet, daß** zur Kompensation des Temperaturganges die beiden Kompensationseingänge (Comp_x, Comp_y) über einen temperaturabhängigen Widerstand mit einer temperaturstabilen Referenzspannung (U_Temp) verbunden sind.

28. Schaltungsanordnung nach Anspruch 26, **dadurch gekennzeichnet, daß** zur Kompensation des Temperaturganges die beiden Kompensationseingänge (Comp_x, Comp_y) mit einem aktiven Temperatursensor verbunden sind.

29. Schaltungsanordnung nach einem der vorhergehenden Ansprüche 26 bis 28, **dadurch gekennzeichnet, daß** zur Kompensation der Nichtlinearität der der Kapazität (C1) bzw. der Kapazitätsänderung proportionalen Ausgangsspannung der Kompensationseingang (Comp_x) über einen Linearisierungs-Widerstand (R7) mit dem Ausgang des Integralreglers (E) bzw. dem Ausgang des Tiefpaß-Filters (F) verbunden ist, und das Verhältnis von Widerstand (R10) des Kompensationseingangs zu Linearisierungs-Widerstand (R7) gleich vs-1 beträgt, wobei v die Verstärkung, s= C3/(Cp + C3) ist und Cp eine konstante zu C1 parallele Kapazität darstellt.

**Claims**

1. A method for measuring small capacitances with a self-balancing bridge circuit (A), with the capacitance or the change in capacitance of an unknown capacitor in a bridge arm or the capacitances or change in capacitances of two unknown capacitors (C1, C2) in two different bridge arms being determined, and the bridge (A) formed by reference capacitors (C2, C3, C4 or C3, C4) and an unknown capacitor (C1) or unknown capacitors (C1, C2) being supplied at two first diagonal points with a periodic, substantially square-wave voltage (T) with constant amplitude, with the square-wave voltage (T) changing within one period from a first (T(0)) level to a second level (T(1)), **characterized in that** continuously the voltage difference at two second diagonal points (X, Y) of the bridge is open-loop gained in a synchronous amplifier (D), preferably a comparator, only during the second level (T(1)), and the synchronous amplifier (D) emits a predetermined potential during the first level (T(0)), whereupon the open-loop gained output signal of the synchronous amplifier is controlled to a setpoint value by means of a loop controller, preferably an integral-action controller (E), which setpoint value is determined by the mean time value of the output voltage of the synchronous amplifier when the bridge is balanced, that the bridge (A) is brought to the balanced condition at the second diagonal points (X, Y) by means of the output voltage of the controller (E) via a negative feedback arm (G) and an adjustable clamping circuit (C), with the output voltage (UA) of the controller (E) being substantially proportional to the capacitance or change in capacitance of the unknown capacitor (C1) or the unknown capacitors (C1, C2).

2. A method as claimed in claim 1, **characterized in that** the integrated voltage is smoothed with a low-pass filter (F), with the smoothed output voltage (U_out) being proportional to the capacitance or change in capacitance of the unknown capacitor (C1) or unknown capacitors (C1, C2).

3. A method as claimed in claim 2, **characterized in that** for the quasi-static capacitance measurement the smoothed output voltage is integrated in a further integral-action controller with respect to a further setpoint value and said integrated voltage is supplied to an input (offset) of the clamping circuit used for the balancing, with the smoothed output voltage being proportional to the capacitance or the change in capacitance of the unknown capacitor (C1) or the difference in capacitance or its change of the unknown capacitors (C1, C2).

4. A circuit arrangement for performing the method according to claim 1, with a bridge circuit (A) formed by reference capacitors (C2, C3, C4 or C3, C4) and one or two unknown capacitances (C1 or C1, C2) being connected at two first diagonal points with a square-wave generator (B) which supplies a constant, substantially rectangular square-wave output voltage (T), **characterized in that** the two second diagonal points (X, Y) are connected with the inputs of a synchronous amplifier (D) which amplifies the difference of the potentials measured at the two second diagonal points (X, Y) only during the second level (T(1)) of the square-wave generator (B), that the output of the synchronous amplifier (D) is connected with a first input of a controller, preferably an integral-action controller (E), and is held at a predetermined potential during the first level (T(0)) of the square-wave voltage, and the output of the controller (E) is connected with the input of the negative-feedback circuit (G), that its output is connected with a first input of a clamping circuit (C), that a second input of the controller (E) is connected with a constant reference voltage source (Ref) and a first or second output of the clamping circuit (C) is connected with the two second diagonal points, with a second input (offset) of the clamping circuit (C) being connected with a balancing voltage source, and that an output voltage can be tapped from the output of the controller (E) which is proportional to the value of the unknown capacitor or the unknown capacitors or their changes.

5. A circuit arrangement as claimed in claim 4, **characterized in that** a low-pass filter (F) is provided downstream of the output of the integral-action controller (E).

6. A circuit arrangement as claimed in claim 5, **characterized in that** the low-pass filter (F) is an active low-pass filter.

7. A circuit arrangement as claimed in claim 6, **characterized in that** the active low-pass filter is formed by a two-pole filter and an RC low pass (R41, C31) is connected in outgoing circuit at its output.

8. A circuit arrangement as claimed in claim 6 or 7, **characterized in that** the active low-pass filter (F) is formed by an operational amplifier with a parallel circuit which is composed of a capacitor (C21) and a resistor (R31) and is coupled between output and inverting input and that the non-inverting input of the operational amplifier is connected with a constant reference voltage.

9. A circuit arrangement as claimed in claim 6, **characterized in that** the active low-pass filter (F) is multi-polar.

10. A circuit arrangement as claimed in one of the preceding claims 4 to 9, **characterized in that** the synchronous amplifier (D) is formed by a differential amplifier, with the output of the differential amplifier being connected for synchronization in series with a resistor and with a switch controlled by the square-wave signal.

11. A circuit arrangement as claimed in one of the preceding claims 4 to 10, **characterized in that** the synchronous amplifier (D) is formed by a sample-and-hold circuit.

12. A circuit arrangement as claimed in claim 11, **characterized in that** the synchronous amplifier (D) is formed by a pulse-duration modulator and the pulse modulation is performed by the dependence of the response time of the output of a differential amplifier from the magnitude of the voltage at the input of the differential amplifier.

13. A circuit arrangement as claimed in claim 12, **char-**

**acterized in that** the pulse-duration modulator comprises a comparator whose inputs are connected with the two second diagonal points (X, Y), with the response time of the output signal of the comparator being a function of the voltage value applied to its input.

14. A circuit arrangement as claimed in claim 13, **characterized in that** the output of the comparator is connected for synchronization via a pull-up resistor (R8) with the output of the square-wave generator (B).

15. A circuit arrangement as claimed in claim 13, **characterized in that** the comparator is provided with a latch or inhibit input.

16. A circuit arrangement as claimed in claim 13 or 15, **characterized in that** the output of the comparator is connected with the base of a switching transistor with a short switching time whose collector forms an open collector.

17. A circuit arrangement as claimed in one of the preceding claims 4 to 16, **characterized in that** the integral-action controller (E) is formed by a differential amplifier in which an integrating capacitor (C5) is provided between output and inverting input, which inverting input forms the input of the integral-action controller by way of a resistor (R9) and in which the non-inverting input is connected with a reference voltage source, with the time constant of the integral-action controller being determined by the product of resistor (R9) and integrating capacitor (C9).

18. A circuit arrangement as claimed in claim 17, **characterized in that** the time constant of the integral-action controller (E) is higher than or equal to the period of the output voltage of the square-wave generator (B).

19. A circuit arrangement as claimed in claim 17, **characterized in that** the ratio of the time constant of the integral-action controller to the period of the square-wave signal lies in a range of between 1 and 10.

20. A circuit arrangement as claimed in claim 17, 18 or 19, **characterized in that** the reference voltage source is provided with a constant voltage whose value is one-quarter of the high level of the square-wave generator (B).

21. A circuit arrangement as claimed in one of the preceding claims 4 to 20, **characterized in that** the negative-feedback circuit (G) is formed by a first negative-feedback resistor (R2) connected with the second diagonal point and a second negative-feedback resistor (R1) which is connected with the same and is connected at its other end with ground.

**22.** A circuit arrangement as claimed in claim 21, **characterized in that** the clamping circuit (C) connects one of the two diagonal points with the connecting point between the negative-feedback resistors (R2, R1) by way of a first clamping resistor (R5) and connects the other of the second diagonal points with the tap point of a voltage divider formed by resistors (R3, R4) by way of a second clamping resistor (R6), with a balancing voltage applied to the second input (offset) of the clamping circuit being divided by the voltage divider.

**23.** A circuit arrangement as claimed in claim 22, **characterized in that** a first or second clamping diode (D1 or D2) is switched parallel to the first or second clamping resistor (R5 or R6).

**24.** A circuit arrangement as claimed in claim 23, **characterized in that** the first and second clamping diode (D1, D2) are arranged as a double diode in a housing.

**25.** A circuit arrangement as claimed in one of the preceding claims 4 to 24, **characterized in that** a further integral-action controller is switched between the output of the low-pass filter (F) and the second input (offset) of the clamping circuit (C).

**26.** A circuit arrangement as claimed in one of the preceding claims 4 to 25, **characterized in that** the reference capacitors (C3, C4) are connected by a resistor (R10, R11) each with the output of the square-wave generator (B), with the connecting points forming compensation inputs (Comp_x, Comp_y) via a diode each (D5, D4) between the reference capacitors (C3, C4) and the resistors (R10, R11).

**27.** A circuit arrangement as claimed in claim 26, **characterized in that** for the compensation of the temperature sensitivity, the two compensation inputs (Comp_x, Comp_y) are connected by way of a thermistor with a temperature-stable reference voltage (U_Temp).

**28.** A circuit arrangement as claimed in claim 26, **characterized in that** for the compensation of the temperature sensitivity, the two compensation inputs (Comp_x, Comp_y) are connected with an active temperature sensor.

**29.** A circuit arrangement as claimed in one of the preceding claims 26 to 28, **characterized in that** compensating for the non-linearity of the output voltage, which is proportional to the capacitance (C1) or the change in capacitance, the compensation input (Comp_x) is connected by way of a linearization resistor (R7) with the output of the integral-action controller (E) or the output of the low-pass filter (F) and the ratio of the resistor (R10) of the compensation input to the linearization resistor (R7) is equal to vs-1, with v being representative of the amplification, s=C3/(Cp + C3) and Cp representing a constant capacitance being parallel to C1.

### Revendications

**1.** Procédé de mesure de petites capacités avec un circuit à pont (A) à équilibrage automatique, dans lequel la capacité ou la modification de la capacité d'un condensateur inconnu (C1) dans une branche du point ou les capacités ou les modifications de la capacité de deux condensateurs inconnus (C1, C2) dans deux branches différentes du pont sont déterminées et le pont (A) formé de condensateurs de référence (C2, C3, C4 ou C3, C4) et d'un condensateur inconnu (C1) ou de condensateurs inconnus (C1, C2) est alimenté en deux premiers points en diagonale sous une tension périodique (T) sensiblement carrée d'amplitude constante, la tension carrée (T) passant d'un premier niveau (T(0)) à un second niveau (T(1)) en une période, **caractérisé en ce que** la différence de tension en deux autres points en diagonale (X, Y) du pont est amplifiée en continu en circuit ouvert, uniquement pendant le deuxième niveau (T(1)) du signal carré, dans un amplificateur synchrone (D), de préférence un comparateur, et l'amplificateur synchrone (D) délivre un potentiel prédéterminé pendant le premier niveau (T(0)), le signal de sortie amplifié en circuit ouvert de l'amplificateur synchrone est ensuite régulé au moyen d'un régulateur, de préférence un régulateur intégral (E), selon une valeur de consigne, laquelle valeur de consigne est déterminée par la moyenne dans le temps de la tension de sortie de l'amplificateur synchrone lorsque le pont est à l'équilibre, **en ce que** le pont (A) est amené à l'équilibre au niveau des deux autres points en diagonale (X, Y) au moyen de la tension de sortie du régulateur (E) par une branche de contre-réaction (G) et un circuit de blocage (C) pouvant être équilibré, la tension de sortie (UA) du régulateur (E) étant sensiblement proportionnelle à la capacité ou à la modification de capacité du condensateur inconnu (C1) ou (C1, C2).

**2.** Procédé selon la revendication 1, **caractérisé en ce que** la tension intégrée est lissée avec un filtre passe-bas (F), la tension de sortie lissée (U_out) étant proportionnelle à la capacité ou à la modification de capacité du condensateur inconnu (C1) ou des condensateurs inconnus (C1, C2).

**3.** Procédé selon la revendication 2, **caractérisé en ce qu'**en vue d'une mesure quasi-statique de la capacité, la tension de sortie lissée est intégrée dans un autre régulateur intégral en fonction d'une autre tension de consigne et cette tension intégrée est amenée à une entrée (écart permanent) du circuit de blocage servant à l'équilibrage, la tension de sortie lissée étant proportionnelle à la capacité ou à la modification de capacité du condensateur inconnu (C1) ou à la différence de capacité ou à la modification de celle-ci pour les condensateurs inconnus (C1, C2).

**4.** Circuit pour l'exécution du procédé selon la revendication 1, dans lequel un circuit en pont (A) formé de condensateurs de référence (C2, C3, C4 ou C3, C4) et d'un condensateur inconnu (C1) ou de condensateurs inconnus (C1, C2) est connecté aux deux premiers points en diagonale à un générateur d'impulsions carrées (B), qui délivre une tension de sortie (T) constante et sensiblement carrée, **caractérisé en ce que** les deux autres points en diagonale (X, Y) sont reliés aux entrées d'un amplificateur synchrone (D) qui amplifie la différence de tension aux deux autres points en diagonale (X, Y) uniquement pendant le deuxième niveau (T(1)) du générateur d'impulsions carrées (B), **en ce que** la sortie de l'amplificateur synchrone (D) est reliée à une première entrée d'un régulateur, de préférence un régulateur intégral (E) et maintenue à un potentiel prédéterminé pendant le premier niveau (T(0)) de la tension carrée, et la sortie du régulateur (E) est reliée à l'entrée d'un circuit de contre-réaction (G), **en ce que** la sortie de celui-ci est reliée à une première entrée d'un circuit de blocage (E), **en ce qu'**une deuxième entrée du régulateur (E) est reliée à une source de tension de consigne constante (Ref) et une première sortie et une seconde sortie du circuit de blocage (C) sont reliées aux deux autres points en diagonale, une deuxième entrée (écart permanent) du circuit de blocage étant reliée à une source de tension d'équilibrage, et **en ce qu'**une tension de sortie proportionnelle à la valeur du ou des condensateurs inconnus ou à ses modifications peut être captée à la sortie du régulateur (E).

**5.** Circuit selon la revendication 4, **caractérisé en ce qu'**un filtre passe-bas (F) est monté en aval de la sortie du régulateur intégral (E),

**6.** Circuit selon la revendication 5, **caractérisé en ce que** le filtre passe-bas (F) est un filtre passe-bas actif.

**7.** Circuit selon la revendication 6, **caractérisé en ce que** le filtre passe-bas actif est formé d'un filtre dipôle et un filtre passe-bas RC (R41, C31) est monté en aval de la sortie de celui-ci.

**8.** Circuit selon la revendication 6 ou 7, **caractérisé en ce que** le filtre passe-bas actif (F) est formée d'un amplificateur opérationnel avec un circuit parallèle, formé d'un condensateur (C21) et d'une résistance (R31), monté entre la sortie et l'entrée d'inversion, et **en ce que** l'entrée non inverseuse de l'amplificateur opérationnel est relié à une tension de référence constante.

**9.** Circuit selon la revendication 6, **caractérisé en ce que** le filtre passe-bas actif (F) est multipôle.

**10.** Circuit selon l'une quelconque des revendications 4 à 9, **caractérisé en ce que** l'amplificateur synchrone (D) est formé d'un amplificateur différentiel, la sortie de l'amplificateur différentiel vers la synchronisation étant montée en série avec une résistance et un commutateur commandé par le signal carré.

**11.** Circuit selon l'une quelconque des revendications 4 à 10, **caractérisé en ce que** l'amplificateur synchrone (D) est formé d'un circuit de détection et de rétention.

**12.** Circuit selon la revendication 11, **caractérisé en ce que** l'amplificateur synchrone (D) est formé d'un modulateur d'amplitude et la modulation des impulsions est réalisée par la dépendance entre le temps de réponse de la sortie d'un amplificateur différentiel et la grandeur de la tension à l'entrée de l'amplificateur différentiel.

**13.** Circuit selon la revendication 12, **caractérisé en ce que** le modulateur d'amplitude comprend un comparateur dont les entrées sont reliées aux deux autres points en diagonale (X, Y), le temps de réponse du signal d'entrée du comparateur étant fonction de la valeur de la tension appliquée à son entrée.

**14.** Circuit selon la revendication 13, **caractérisé en ce que** la sortie du comparateur vers la synchronisation est reliée à la sortie du générateur d'impulsions carrées (B) par une résistance de rappel au niveau haut (R8).

**15.** Circuit selon la revendication 13, **caractérisé en ce que** le comparateur présente une entrée de verrouillage ou d'inhibition.

**16.** Circuit selon la revendication 13 ou 15, **caractérisé en ce que** la sortie du comparateur est reliée avec la base d'un transistor de commutation à temps de commutation court, dont le collecteur forme un collecteur ouvert.

**17.** Circuit selon l'une quelconque des revendications 4 à 16, **caractérisé en ce que caractérisé en ce que** le régulateur intégral (E) est formé d'un amplificateur différentiel dans lequel un condensateur intégré (C5) est prévu entre la sortie et l'entrée inverseuse laquelle entrée inverseuse forme, via une résistance (R9), l'entrée du régulateur intégral, et dans lequel l'entrée non inverseuse est reliée à une source de tension de consigne, la constante temporelle du régulateur intégral étant déterminé par le produit de la résistance (R9) et du condensateur intégré (C9).

**18.** Circuit selon la revendication 17, **caractérisé en ce que** la constante de temps du régulateur intégral (E) est supérieure ou égale à la période de la tension de sortie du générateur d'impulsions carrées (B).

**19.** Circuit selon la revendication 17, **caractérisé en ce que** le rapport entre la constante temporelle du régulateur intégral et la période du signal carré est compris entre 1 et 10.

**20.** Circuit selon la revendication 17, 18 ou 19, **caractérisé en ce que** la source de tension de consigne présente une tension constante dont la valeur est égale au quart du niveau haut du générateur d'impulsions carrées (B).

**21.** Circuit selon l'une quelconque des revendications 4 à 20, **caractérisé en ce que** le circuit de contre-réaction (G) est formé d'une première résistance de contre-réaction (R2) reliée avec l'un des deux autres points en diagonale et d'une seconde résistance de contre-réaction (R1) reliée à celle-ci et mise à la masse à son autre extrémité.

**22.** Circuit selon la revendication 21, **caractérisé en ce que** le circuit de blocage (C) relie, via une première résistance de blocage (R5), l'un des deux autres points en diagonale et le point de connexion entre les résistances de contre-réaction (R2, R1) et relie, via une seconde résistance de blocage (R6) l'autre des deux autres points en diagonale avec le point de captage d'un diviseur de tension composé de résistances (R3, R4), une tension d'équilibrage étant divisée par un diviseur de tension à la deuxième entrée (écart permanent) du circuit de blocage.

**23.** Circuit selon la revendication 22, **caractérisé en ce qu'**une première et une seconde diode de blocage (D1 et D2) sont montées en parallèle, respectivement, avec la première et la seconde résistance de blocage (R5 et R6).

**24.** Circuit selon la revendication 23, **caractérisé en ce que** la première diode de blocage et la seconde (D1, D2) sont disposées dans un même logement sous la forme d'une duo-diode.

**25.** Circuit selon l'une quelconque des revendications 4 à 24, **caractérisé en ce qu'**un autre régulateur intégral est monté entre la sortie du filtre passe-bas (F) et la deuxième entrée (écart permanent) du circuit de blocage (C).

**26.** Circuit selon l'une quelconque des revendications 4 à 25, **caractérisé en ce que** les condensateurs de référence (C3, C4) sont connectés, via une résistance (R10, R11) chacun, à la sortie du générateur d'impulsions carrées (B), les points de connexion entre les condensateurs de référence (C3, C4) et les résistances (R10, R11) formant, via une diode (D5, D4) chacun, des entrés de compensation (Comp_x, Comp_y).

**27.** Circuit selon la revendication 26, **caractérisé en ce qu'**en vue de la compensation de l'évolution thermique, les deux entrées de compensation (Comp_x, Comp_y) sont reliées via une résistance variable avec la température à une tension de référence invariable avec la température (U_Temp).

**28.** Circuit selon la revendication 26, **caractérisé en ce qu'**en vue de la compensation de l'évolution thermique, les deux entrées de compensation (Comp_x, Comp_y) sont reliées à un capteur thermique actif.

**29.** Circuit selon l'une quelconque des revendications 26 à 28, **caractérisé en ce qu'**en vue de compenser l'absence de linéarité de la tension de sortie proportionnelle à la capacité (C1) ou à la modification de capacité, l'entrée de compensation (Comp_x) est reliée via une résistance de linéarisation (R7) à la sortie du régulateur intégral (E) ou à la sortie du filtre passe-bas (F), et le rapport entre la résistance (R10) de l'entrée de compensation et la résistance de linéarisation (R7) est égal à vs-1, où v est l'amplification, s = C3/(Cp+C3) et Cp est une capacité constante parallèle à C1.

Clock T

$T(0) = 0 \, V$
$T(1) = UB$

$X(1) = X(0) + \Delta X$
$Y(1) = Y(0) + \Delta Y$

$\Delta X = C3 / (C1 + C3)$
$\Delta Y = C4 / (C2 + C4)$

**FIG. 1a**

gewählt : $X(1) = Y(1)$ $\longrightarrow$ $X(0) = X(1) - \Delta X$
$Y(0) = Y(1) - \Delta Y$

$C1 > C2$

**FIG. 1b**

FIG. 2a

FIG.2b

FIG. 3

overdrive
[mV]

FIG. 4a

FIG. 4b

a response time
b active time ( on )
c clock low

FIG. 4c

Offset

U_out

Ref

Integralregler

Ref

FIG.5

FIG. 6

FIG. 7

FIG. 8

FIG.9

EP 0 745 861 B1